# EUROPEAN PATENT SPECIFICATION

(11) **EP 3 890 012 B1**
(45) Date of publication and mention of the grant of the patent: **19.04.2023**
(21) Application number: 21161333.6
(22) Date of filing: 08.03.2021
(51) Int. Cl.: H01L 25/075, H01L 33/62, H01L 25/16

(54) **DISPLAY DEVICE AND MANUFACTURING METHOD THEREOF**
ANZEIGEVORRICHTUNG UND DEREN HERSTELLUNGSVERFAHREN
AFFICHEUR ET SON PROCÉDÉ DE FABRICATION

(30) Priority: 11.03.2020 KR 20200030366
(43) Date of publication of application: 06.10.2021
(73) Proprietor: Samsung Display Co., Ltd., Yongin-si, Gyeonggi-Do 17113 (KR)
(72) Inventor: YANG, Yong Hoon, 17113 Yongin-si (KR); KO, Min Suk, 17113 Yongin-si (KR); KIM, Si Kwang, 17113 Yongin-si (KR); SEO, Kab Jong, 17113 Yongin-si (KR)
(74) Representative: Marks & Clerk LLP

(56) References cited:
- WO-A1-2020/013386
- WO-A1-2020/017719
- WO-A1-2020/022596

## Description

### BACKGROUND

### 1. Field

Some embodiments of the present disclosure relate to a display device and to a manufacturing method thereof.

### 2. Description of the Related Art

A light emitting diode may exhibit relatively good durability even in a harsh environment, and may have excellent performance in terms of a life-span and luminance.

To apply the light emitting diode to a lighting device or to a display device, it may be suitable to connect an electrode capable of applying power to the light emitting diode. An arrangement relationship between the light emitting diode and the electrode has been studied in various ways while considering a use purpose, a reduction in space occupied by the electrode, a manufacturing method, and/or a driving method.

For instance, document WO 2020/022596 A1 and its patent family member EP 3 832 740 A1 disclose a display device with very small light emitting diodes disposed between two banks. Electrodes disposed on the banks are connected to the electrodes of the light emitting diodes.

### SUMMARY

Some embodiments of the present disclosure provide a display device formed by a simple manufacturing process by reducing the number of masks and a manufacturing method thereof.

A display device according to some embodiments of the present disclosure includes a substrate, a first bank pattern and a second bank pattern on the substrate and spaced apart from each other, a first electrode on the first bank pattern, and a second electrode on the second bank pattern, a light emitting element between the first bank pattern and the second bank pattern, an insulation pattern on the light emitting element, and exposing a first end and a second end of the light emitting element respectively adjacent to the first bank pattern and the second bank pattern, a third electrode contacting the first electrode and the first end of the light emitting element, and a fourth electrode contacting the second electrode and the second end of the light emitting element, wherein a thickness of the insulation pattern is within a range of about 50% to about 150% of a thickness of the first bank pattern.

The third electrode and the fourth electrode may include the same material, and may be formed on the same layer.

With respect to the substrate, a maximum height of an upper surface of the insulation pattern may be greater than or equal to a height of an upper surface of the first bank pattern or second bank pattern.

With respect to the substrate, the maximum height of the upper surface of the insulation pattern may be equal to the height of the upper surface of the first bank pattern.

The insulation pattern may include side surfaces respectively facing the first electrode and the second electrode, and an upper surface between the side surfaces, wherein the third electrode does not overlap with the upper surface of the insulation pattern.

The first bank pattern may include a first side surface facing the first end of the light emitting element, and an upper surface that is parallel to the upper surface of the substrate, wherein the third electrode is on the first side surface of the first bank pattern.

The third electrode might not overlap with a top surface of the first bank pattern.

The display device may further include a dummy electrode spaced apart from the third electrode, and contacting a second side surface of the first bank pattern facing the first side surface of the first bank pattern, and a fifth electrode on one side surface of the second bank pattern, and spaced apart from the fourth electrode.

With respect to the substrate, a height of one end of the third electrode contacting the first end of the light emitting element may be equal to a height of the other end of the third electrode contacting the first electrode.

A distance between the third electrode and the fourth electrode may vary along a direction in which the third and fourth electrodes extend in a plane view.

A distance between the third electrode and the fourth electrode in an overlapping portion that overlaps the light emitting element may be greater than a distance between the third electrode and the fourth electrode in a non-overlapping portion that does not overlap the light emitting element.

With respect to the substrate, a height of an upper surface of the insulation pattern overlapping with the light emitting element may be equal to a maximum height of an upper surface of the first electrode, and a height of the upper surface of the insulation pattern that does not overlap with the light emitting element may be about equal to a height of the upper surface of the first bank pattern.

With respect to the substrate, a height of an upper surface of the insulation pattern may be greater than a maximum height of an upper surface of the first electrode.

The first bank pattern may include an upper surface that is parallel to the upper surface of the substrate, wherein the third electrode does not overlap with the upper surface of the first bank pattern.

The display device may further include a pixel circuit layer between the substrate and the first bank pattern, and including at least one transistor electrically connected to the first electrode or the second electrode.

The first bank pattern may directly cover one of a source electrode or a drain electrode of the at least one transistor, which is connected to the first electrode or to the second electrode through a contact hole in the first bank pattern.

A manufacturing method of a display device according to some embodiments of the present disclosure includes forming a first bank pattern and a second bank pattern spaced apart on a substrate, forming a first electrode and a second electrode on the first bank pattern and the second bank pattern, respectively, aligning a light emitting element between the first bank pattern and the second bank pattern, forming an insulation pattern exposing a first end and a second end of the light emitting element that are adjacent to the first bank pattern and the second bank pattern on the light emitting element, respectively, forming an electrode layer covering the first electrode, the second electrode, and the insulation pattern on the substrate, forming a photoresist on the electrode layer, and forming a third electrode and a fourth electrode from the electrode layer by using an etching technology to remove at least a portion of the photoresist and a first portion of the electrode layer that overlaps with the insulation pattern.

A thickness of the insulation pattern may be within a range of 50% to about 150% of a thickness of the first bank pattern.

The forming the third electrode and the fourth electrode may include forming a dummy electrode from the electrode layer by removing a portion of the electrode layer overlapping with the first bank pattern, the dummy electrode being spaced apart from the third electrode.

With respect to the substrate, a height of an upper surface of the insulation pattern may be greater than a maximum height of an upper surface of the first electrode.

At least some of the above and other features of the invention are set out in the claims.

In a display device according to some embodiments of the present disclosure, a thickness of the second insulation layer (or insulation pattern) located on the light emitting element may be within a range of about 50% to about 150% of a thickness of the bank pattern. With respect to the substrate, a height of the upper surface of the second insulation layer may be greater than or about equal to a height of the upper surface of the bank pattern. Therefore, the first and second contact electrodes may be formed substantially simultaneously or concurrently through a single etching process without a separate mask (and without an exposure process, or a photolithography process).

In addition, a manufacturing method of a display device according to some embodiments of the present disclosure may substantially simultaneously or concurrently form the first contact electrode (the third electrode) and the second contact electrode (the fourth electrode) from the contact electrode layer by forming a photoresist on the contact electrode layer, and by removing a portion of the photoresist and a portion of the contact electrode layer (e.g., a portion overlapping with the second insulation layer) through a dry etching. Therefore, a number of masks used in the manufacturing process may be reduced, and the manufacturing process of the display device may be simplified.

### BRIEF DESCRIPTION OF THE DRAWINGS

FIG. 1A is a drawing showing a light emitting element according to some embodiments of the present disclosure.
FIG. 1B is a cross-sectional view of a light emitting element of FIG. 1A.
FIG. 2A is a drawing showing a light emitting element according to some embodiments of the present disclosure.
FIG. 2B is a cross-sectional view of a light emitting element of FIG. 2A.
FIG. 3A is a drawing showing a light emitting element according to some embodiments of the present disclosure.
FIG. 3B is a cross-sectional view of a light emitting element of FIG. 3A.
FIG. 4A is a drawing showing a light emitting element according to some embodiments of the present disclosure.
FIG. 4B is a cross-sectional view of a light emitting element of FIG. 4A.
FIG. 5 is a top plan view showing a display device according to some embodiments of the present disclosure.
FIGS. 6A to 6E are circuit diagrams showing an example of a pixel included in a display device of FIG. 5.
FIGS. 7A and 7B are circuit diagrams showing other examples of a pixel included in a display device of FIG. 5.
FIG. 8 is a top plan view showing an example of a pixel included in a display device of FIG. 5.
FIG. 9 is a cross-sectional view showing an example of a pixel taken along the line I-I' of FIG. 8.
FIG. 10 is an enlarged cross-sectional view of the Q2 area of FIG. 9.
FIG. 11A is a top plan view enlarging the Q1 area of FIG. 8.
FIG. 11B is a cross-sectional view showing an example of a pixel taken along the line II-II' of FIG. 11A.
FIGS. 12 to 14 are cross-sectional views showing another example of a pixel taken along the line I-I' of FIG. 8.
FIGS. 15A to 15H are cross-sectional views sequentially showing a manufacturing method of a display device according to some embodiments of the present disclosure.
FIG. 16 is a top plan view showing an example of a pixel included in a display device of FIG. 5.
FIG. 17 is a cross-sectional view showing an example of a pixel taken along the line III-III' of FIG. 16.
FIGS. 18A to 18C are cross-sectional views sequentially showing a manufacturing method of a display device according to some embodiments of the present disclosure.

### DETAILED DESCRIPTION

Features of the inventive concept and methods of accomplishing the same may be understood more readily by reference to the detailed description of embodiments and the accompanying drawings. Hereinafter, embodiments will be described in more detail with reference to the accompanying drawings. The described embodiments, however, may be embodied in various different forms, and should not be construed as being limited to only the illustrated embodiments herein. Rather, these embodiments are provided as examples so that this disclosure will be thorough and complete, and will fully convey the aspects and features of the present inventive concept to those skilled in the art. Accordingly, processes, elements, and techniques that are not necessary to those having ordinary skill in the art for a complete understanding of the aspects and features of the present inventive concept might not be described.

Unless otherwise noted, like reference numerals, characters, or combinations thereof denote like elements throughout the attached drawings and the written description, and thus, descriptions thereof will not be repeated. Further, parts not related to the description of the embodiments might not be shown to make the description clear. In the drawings, the relative sizes of elements, layers, and regions may be exaggerated for clarity.

Various embodiments are described herein with reference to sectional illustrations that are schematic illustrations of embodiments and/or intermediate structures. As such, variations from the shapes of the illustrations as a result, for example, of manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the particular illustrated shapes of regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the drawings are schematic in nature and their shapes are not intended to illustrate the actual shape of a region of a device and are not intended to be limiting. Additionally, as those skilled in the art would realize, the described embodiments may be modified in various different ways, all without departing from the scope of the present disclosure.

In the detailed description, for the purposes of explanation, numerous specific details are set forth to provide a thorough understanding of various embodiments. It is apparent, however, that various embodiments may be practiced without these specific details or with one or more equivalent arrangements. In other instances, well-known structures and devices are shown in block diagram form to avoid unnecessarily obscuring various embodiments.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, in this specification, the phrase "on a plane," or "plan view," means viewing a target portion from the top, and the phrase "on a cross-section" means viewing a cross-section formed by vertically cutting a target portion from the side.

It will be understood that when an element, layer, region, or component is referred to as being "formed on," "on," "connected to," or "coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. However, "directly connected/directly coupled" refers to one component directly connecting or coupling another component without an intermediate component. Meanwhile, other expressions describing relationships between components such as "between," "immediately between" or "adjacent to" and "directly adjacent to" may be construed similarly. In addition, it will also be understood that when an element or layer is referred to as being "between" two elements or layers, it can be the only element or layer between the two elements or layers, or one or more intervening elements or layers may also be present.

For the purposes of this disclosure, expressions such as "at least one of," when preceding a list of elements, modify the entire list of elements and do not modify the individual elements of the list. For example, "at least one of X, Y, and Z," "at least one of X, Y, or Z," and "at least one selected from the group consisting of X, Y, and Z" may be construed as X only, Y only, Z only, any combination of two or more of X, Y, and Z, such as, for instance, XYZ, XYY, YZ, and ZZ, or any variation thereof. Similarly, the expression such as "at least one of A and B" may include A, B, or A and B. As used herein, the term "and/or" includes any and all combinations of one or more of the associated listed items. For example, the expression such as "A and/or B" may include A, B, or A and B.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items.

As used herein, the term "substantially," "about," "approximately," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (e.g., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

When one or more embodiments may be implemented differently, a specific process order may be performed differently from the described order. For example, two consecutively described processes may be performed substantially at the same time or performed in an order opposite to the described order.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

Unless otherwise defined, all terms (including technical and scientific terms) used herein have the same meaning as commonly understood by one of ordinary skill in the art to which the present inventive concept belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

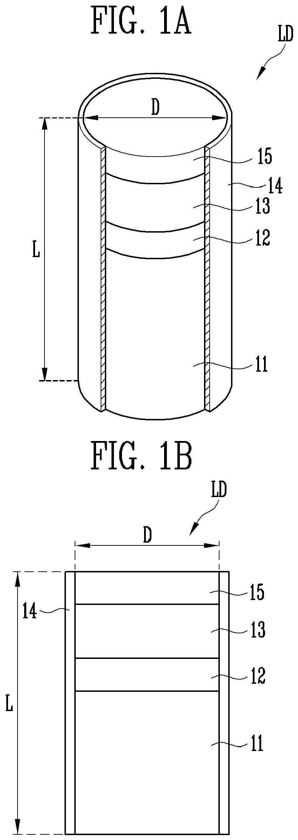

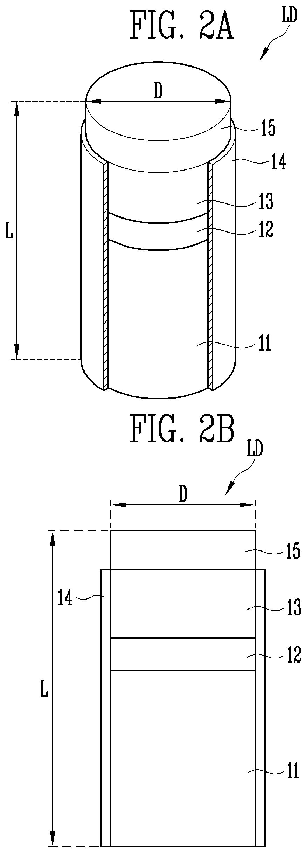

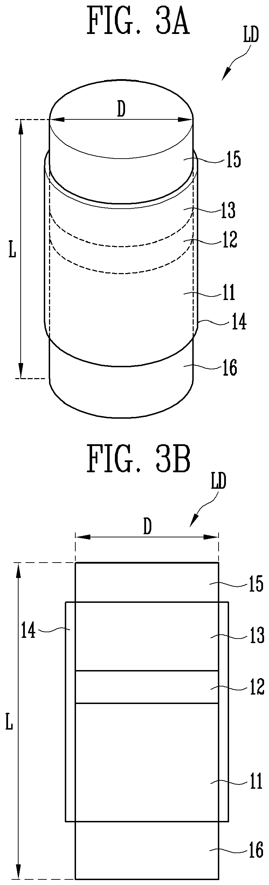

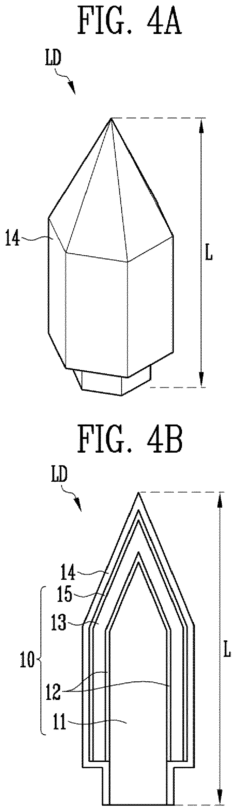

FIG. 1A is a drawing showing a light emitting element according to some embodiments of the present disclosure. FIG. 1B is a cross-sectional view of a light emitting element of FIG. 1A. FIG. 2A is a drawing showing a light emitting element according to some embodiments of the present disclosure. FIG. 2B is a cross-sectional view of a light emitting element of FIG. 2A. FIG. 3A is a drawing showing a light emitting element according to some embodiments of the present disclosure. FIG. 3B is a cross-sectional view of a light emitting element of FIG. 3A. FIG. 4A is a drawing showing a light emitting element according to some embodiments of the present disclosure. FIG. 4B is a cross-sectional view of a light emitting element of FIG. 4A.

FIGS. 1A, 1B, 2A, 2B, 3A, and 3B show a light emitting element manufactured by an etching technology and are described below, and FIGS. 4A and 4B show a light emitting element manufactured by a growth method and will be described thereafter. A type and/or shape of the light emitting element is not limited to the embodiments shown in FIGS. 1A, 1B, 2A, 2B, 3A, 3B, 4A, and 4B.

First, referring to FIGS. 1A, 1B, 2A, 2B, 3A, and 3B, the light emitting element LD may include a first semiconductor layer 11, a second semiconductor layer 13, and an active layer 12 interposed between the first semiconductor layer 11 and the second semiconductor layer 13. For example, the light emitting element LD may be implemented as a light emitting stacking member in which the first semiconductor layer 11, the active layer 12, and the second semiconductor layer 13 are sequentially stacked.

In some embodiments, the light emitting element LD may have a shape extending in one direction. If an extending direction/extension direction of the light emitting element LD is referred to as a length direction, the light emitting element LD may have opposite ends extending in the extending direction. One of the first and second semiconductor layers 11 and 13 may be located on one end of the light emitting element LD, and the other of the first and second semiconductor layers 11 and 13 may be located on the other end of the light emitting element LD.

The light emitting element LD may have various shapes. For example, the light emitting element LD may have a rod-like shape or a bar-like shape that is longer in the length direction (e.g., may have an aspect ratio that is greater than one). For example, a length L of the light emitting element LD in the length direction may be greater than a diameter D (or may be greater than a width of a transverse cross-section) thereof. The light emitting element LD may include a light emitting diode manufactured in an ultra-small size to have a diameter D and/or length L of a micro scale or of a nano scale. A size of the light emitting element LD may be changed so that the light emitting element LD may meet a suitable condition/design condition of a corresponding lighting device or self-luminous display device.

The first semiconductor layer 11 may include at least one N-type semiconductor layer. For example, the first semiconductor layer 11 may include any one semiconductor material of InAlGaN, GaN, AlGaN, InGaN, AIN, and InN, and may include an N-type semiconductor layer doped with a first conductive dopant such as Si, Ge, Sn, and the like. However, the material constituting the first semiconductor layer 11 is not limited thereto, and various other materials may constitute the first semiconductor layer 11.

The active layer 12 may be located on the first semiconductor layer 11, and may be formed in a single or multiple quantum well structure. A position of the active layer 12 may be variously changed according to the type of light emitting element LD. The active layer 12 may emit light having a wavelength of about 400 nm to about 900 nm, and may use a double heterostructure. In some embodiments, a cladding layer doped with conductive dopant may be formed on an upper and/or lower portion of the active layer 12. For example, the cladding layer may be formed of an AlGaN layer or an InAlGaN layer. According to some embodiments, the material such as AlGaN, InAlGaN, and the like may be used to form the active layer 12, and various materials may constitute the active layer 12.

When an electric field having a voltage (e.g., having a predetermined voltage or more) is applied to both ends of the light emitting element LD, the light emitting element LD emits light while electron-hole pairs are combined in the active layer 12. By controlling light emission of the light emitting element LD using this principle, the light emitting element LD may be used as a light source for various light emitting devices, as well as a pixel of a display device.

The second semiconductor layer 13 may be located on the active layer 12, and may include a semiconductor layer that is of a different type from the first semiconductor layer 11. The second semiconductor layer 13 may include at least one P-type semiconductor layer. For example, the second semiconductor layer 13 may include at least one semiconductor material of InAlGaN, GaN, AlGaN, InGaN, AIN, and InN, and may include a P-type semiconductor layer doped with a second conductive dopant such as Mg and the like. However, the material constituting the second semiconductor layer 13 is not limited thereto, and various other materials may constitute the second semiconductor layer 13.

In some embodiments of the present disclosure, the first semiconductor layer 11 and the second semiconductor layer 13 may have different widths (or thicknesses) in the length direction of the light emitting element LD. For example, the first semiconductor layer 11 may have a wider width (or a thicker thickness) than that of the second semiconductor layer 13 with respect to the length direction of the light emitting element LD. Accordingly, as shown in FIGS. 1A to 3B, the active layer 12 of the light emitting element LD may be closer to the upper surface of the second semiconductor layer 13 than it is to the lower surface of the first semiconductor layer 11.

In some embodiments, the light emitting element LD may further include an additional electrode 15 located on the second semiconductor layer 13 in addition to the first semiconductor layer 11, the active layer 12, and the second semiconductor layer 13 described above. In addition, according to some embodiments, as shown in FIGS. 3A and 3B, the light emitting element LD may further include another additional electrode 16 located on one end of the first semiconductor layer 11.

The additional electrodes 15 and 16 may be ohmic contact electrodes, but are not limited thereto, and may be Schottky contact electrodes according to some embodiments. The additional electrodes 15 and 16 may include metal or metal oxide, for example, chromium (Cr), titanium (Ti), aluminium (Al), gold (Au), nickel (Ni), ITO and oxide or alloy thereof alone or in combination, but the present disclosure is not limited thereto.

The material included in each of the additional electrodes 15 and 16 may be the same as, or different from, each other. The additional electrodes 15 and 16 may be substantially transparent or translucent. Accordingly, the light generated by the light emitting element LD may transmit through the additional electrodes 15 and 16 to be emitted outside of the light emitting element LD. According to some embodiments, the additional electrodes 15 and 16 may include opaque metal, wherein the light generated from the light emitting element LD is emitted to the outside of the light emitting element LD through an area excluding both ends of the light emitting element LD without passing through the additional electrodes 15 and 16.

In some embodiments, the light emitting element LD may further include an insulation film 14. However, according to some embodiments, the insulation film 14 may be omitted, or may be provided to cover only a portion of the first semiconductor layer 11, the active layer 12, and the second semiconductor layer 13.

The insulation film 14 may reduce the likelihood of, or prevent, an electric short that may otherwise occur when the active layer 12 contacts a conductive material other than the first semiconductor layer 11 and the second semiconductor layer 13. In addition, by forming the insulation film 14, a surface defect of the light emitting element LD may be reduced or minimized to improve life-span and efficiency. In addition, when a plurality of light emitting elements LD are closely located, the insulation film 14 may reduce the likelihood of, or prevent, an unwanted short that may otherwise occur between the light emitting elements LD. In some embodiments, the short may be prevented between the active layer 12 and an external conductive material whether or not the insulation film 14 is provided.

As shown in FIGS. 1A and 1B, the insulation film 14 may be provided in a form entirely surrounding an outer circumferential surface of the light emitting stacking member including the first semiconductor layer 11, the active layer 12, the second semiconductor layer 13, and the additional electrode 15. For better understanding and for ease of description, FIG. 1A shows a state wherein a portion of the insulation film 14 is removed, and wherein the first semiconductor layer 11, the active layer 12, the second semiconductor layer 13, and the additional electrode 15 included in the real light emitting element LD may be surrounded by the insulation film 14.

The insulation film 14 may have a form that entirely surrounds the outer circumferential surface of each of the first semiconductor layer 11, the active layer 12, the second semiconductor layer 13, and the additional electrode 15, but the present disclosure is but not limited thereto.

According to some embodiments, as shown in FIGS. 2A and 2B, the insulation film 14 may surround the outer circumferential surface of each of the first semiconductor layer 11, the active layer 12, and the second semiconductor layer 13 without entirely surrounding the outer circumferential surface of the additional electrode 15 located on the second semiconductor layer 13. Alternatively, the insulation film 14 may surround only a portion of the outer circumferential surface of the additional electrode 15 while not surrounding the rest of the outer circumferential surface of the additional electrode 15. However, the insulation film 14 may expose both ends of the light emitting element LD. For example, the insulation film 14 may expose one end of the first semiconductor layer 11 in addition to the additional electrode 15 located on one side of the second semiconductor layer 13. In addition, according to some embodiments, as shown in FIGS. 3A and 3B, when additional electrodes 15 and 16 are located at respective ends of the light emitting element LD, the insulation film 14 may expose at least one region of each of the additional electrodes 15 and 16. Alternatively, in other embodiments, the insulation film 14 may be omitted.

According to some embodiments of the present disclosure, the insulation film 14 may include a transparent insulation material. For example, the insulation film 14 may include at least one insulation material selected from the group consisting of SiO₂, Si₃N₄, Al₂O₃ and TiO₂, but is not limited thereto, and may include various materials having an insulation property.

When the insulation film 14 is provided to the light emitting element LD, it is possible to reduce or prevent the likelihood of the active layer 12 being shorted with the first electrode and/or second electrode. In addition, by forming the insulation film 14, the surface defect of the light emitting element LD may be reduced or minimized to improve life-span and efficiency. In addition, when a plurality of light emitting elements LD are closely located, the insulation film 14 may reduce or prevent unwanted shorts that may otherwise occur between the light emitting elements LD.

The light emitting element LD may be used as a light emitting source for various display devices. The light emitting element LD may be manufactured through a surface treatment process. For example, when a plurality of light emitting elements LD is mixed with a fluid solution or solvent, and is supplied to each light emitting area (e.g., to the light emitting area of each pixel or sub-pixel), each light emitting element LD may be surface-treated so that the light emitting elements LD may be uniformly sprayed without non-uniform agglomeration in the solution.

A light emitting device including the light emitting element LD may be used in various types of devices that require a light source, including a display device. For example, when locating a plurality of light emitting elements LD in the light emitting area of each pixel of the display panel, the light emitting elements LD may be used as the light source of each pixel. However, a field of application of the light emitting element LD is not limited to the embodiments described above. For example, the light emitting element LD may be also used in other types of devices that require a light source, such as a lighting device.

Next, Referring to FIGS. 4A and 4B, the light emitting element LD manufactured by a growth method will be described.

In the description of the light emitting element LD manufactured by the growth method, a description will be made focusing on the differences from the previously described embodiments, and portions not specifically described in the light emitting element LD manufactured by the growth method are in accordance with the embodiment described above.

Referring to FIGS. 4A and 4B, the light emitting element LD according to some embodiments of the present disclosure may include the first semiconductor layer 11, the second semiconductor layer 13, and the active layer 12 interposed between the first and second semiconductor layers 11 and 13. According to some embodiments, the light emitting element LD may include: a light emitting pattern 10 of a core-shell structure having the first semiconductor layer 11 located at the center; the active layer 12 surrounding at least one side of, or a portion of, the first semiconductor layer 11; the second semiconductor layer 13 surrounding at least one side of, or a portion of, the active layer 12; and an additional electrode 15 surrounding at least one side of, or a portion of, the second semiconductor layer 13.

The light emitting element LD may be provided in a polygonal horn shape extending in one direction. For example, the light emitting element LD may be provided in a hexagonal horn shape. When the extending direction of the light emitting element LD is referred to as a length direction L, the light emitting element LD may have one end (e.g., a lower end) and the other end (e.g., an upper end) in the length direction L. At one end (e.g., at the lower end) of the light emitting element LD, a portion of one of the first and second semiconductor layers 11 and 13 may be exposed, and at the other end (e.g., at the upper end) of the light emitting element LD, a portion of the other of the first and second semiconductor layers 11 and 13 may be exposed. For example, a portion of the first semiconductor layer 11 may be exposed at one end (e.g., the lower end) of the light emitting element LD, and a portion of the second semiconductor layer 13 may be exposed at the other end (e.g., the upper end) of the light emitting element LD. In this case, when the light emitting element LD is used as a light source of the display device, the exposed portion of the first semiconductor layer 11 may contact one of driving electrodes for driving the light emitting element LD, and the exposed portion of the second semiconductor layer 13 may contact the other driving electrode.

According to some embodiments, when the light emitting element LD includes an additional electrode 15, a portion of the additional electrode 15 surrounding the at least one side of the second semiconductor layer 13 may be exposed at the other end (e.g., the upper end) of the light emitting element LD. In this case, when the light emitting element LD is used as a light source of the display device, the exposed portion of the additional electrode 15 may contact the other driving electrode to be electrically connected to one electrode.

In some embodiments, the first semiconductor layer 11 may be located at a core or center of the light emitting element LD. The light emitting element LD may be provided in a shape corresponding to a shape of the first semiconductor layer 11. For example, when the first semiconductor layer 11 has a hexagonal horn shape, the light emitting element LD and the light emitting pattern 10 may also have a hexagonal horn shape.

The active layer 12 may be provided and/or formed to surround the outer circumferential surface of the first semiconductor layer 11 in the length direction L of the light emitting element LD. For example, the active layer 12 may be provided and/or formed to surround an area that excludes the other end (e.g., the lower side) of the first semiconductor layer 11 in the length direction L of the light emitting element LD.

The second semiconductor layer 13 may be provided and/or formed to surround the active layer 12 in the length direction L of the light emitting element LD, and may include a semiconductor layer that is of a different type than the first semiconductor layer 11. For example, the second semiconductor layer 13 may include at least one P-type semiconductor layer.

In some embodiments, the light emitting element LD may include an additional electrode 15 surrounding at least one side of the second semiconductor layer 13. The additional electrode 15 may be an ohmic contact electrode that is electrically connected to the second semiconductor layer 13 or a Schottky contact electrode, but is not limited thereto.

As described above, the light emitting element LD may be implemented as a hexagonal horn shape wherein both ends thereof protrude, and may be implemented as a light emitting pattern 10 of a core-shell structure including the first semiconductor layer 11 at the center thereof, the active layer 12 surrounding the first semiconductor layer 11, the second semiconductor layer 13 surrounding the active layer 12, and an additional electrode 15 surrounding the second semiconductor layer 13. The first semiconductor layer 11 may be at one end (or lower end) of the light emitting element LD having a hexagonal horn shape, and the additional electrode 15 may be located at the other end (or upper end) of the light emitting element LD.

In addition, according to some embodiments, the light emitting element LD may further include an insulation film 14 provided on an outer circumferential surface of the light emitting pattern 10 having a core-shell structure. The insulation film 14 may include a transparent insulation material.

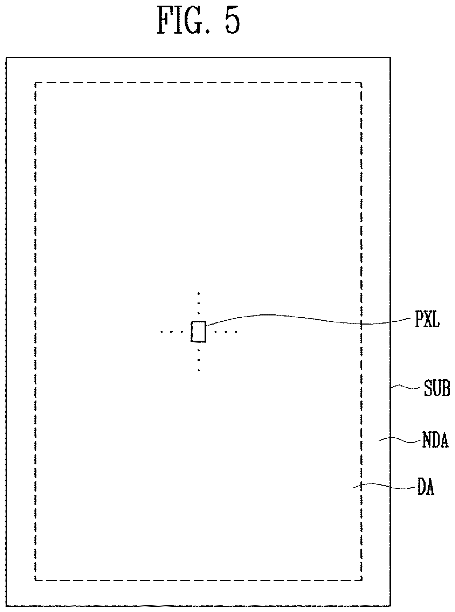

FIG. 5 is a top plan view showing a display device according to some embodiments of the present disclosure. FIG. 5 is a schematic top plan view of a display device using one of the light emitting elements shown in FIGS. 1A, 1B, 2A, 2B, 3A, 3B, 4A, and 4B as a light emitting source.

In FIG. 5, for better understanding and ease of description, the structure of the display device is briefly illustrated centering the display area where the image is displayed. However, according to some embodiments, at least one driver (e.g., a scan driver, a data driver, etc.) and/or a plurality of signal lines may be further arranged on the display device.

Referring to FIGS. 1A to 5, the display device according to some embodiments of the present disclosure may include a substrate SUB, a plurality of pixels PXL provided on the substrate SUB and including at least one light emitting element LD, a driver provided on the substrate SUB and driving the pixels PXL, and a line unit for connecting the pixels PXL and the driver.

The display device may be classified as a display device of a passive matrix type, or as a display device of an active matrix type, according to the method of driving the light emitting element LD. For example, when the display device is implemented as the active matrix type, each of the pixels PXL may include a driving transistor that controls an amount of current supplied to the light emitting element LD, and may include a switching transistor that transfers a data signal to the driving transistor.

In view of resolution, contrast, and operation speed, the display device of the active matrix type, wherein each pixel PXL is selected and turned on and off, has become mainstream, but the present disclosure is not limited thereto. The display device of the passive matrix type, which is turned on and off for each group of the pixels PXL, may also use constituent elements (e.g., first and second electrodes) for driving the light emitting element LD.

The substrate SUB may include a display area DA and a non-display area NDA.

According to some embodiments, the display area DA may be located in a central area of the display device, and the non-display area NDA may be located at an edge area of the display device to surround the display area DA. However, positions of the display area DA and the non-display area NDA are not limited thereto, and the positions thereof may be changed.

The display area DA may be an area in which pixels PXL for displaying an image are provided. The non-display area NDA may be an area in which a driver for driving the pixels PXL, and a portion of the line unit connecting the pixels PXL and the driver, are provided.

The display area DA may have various shapes. For example, the display area DA may be provided as a closed polygon including sides comprising a straight line. In addition, the display area DA may be provided as a circular shape and/or elliptical shape including sides comprising a curved line. In addition thereto, the display area DA may be provided as various shapes, such as a semicircle or a semi-ellipse, including sides comprising a straight line and/or a curved line.

The non-display area NDA may be provided on at least one side of the display area DA. In some embodiments of the present disclosure, the non-display area NDA may surround a circumference, or edge, of the display area DA.

In the non-display area NDA, a first line unit connected to the pixels PXL, and a second line unit connected to the first line unit and to a driver for driving the pixels PXL, may be provided.

The line unit(s) may electrically connect the driver and the pixels PXL. The line unit(s) may be a fan-out line that is connected to a signal line that provides a signal to each pixel PXL, and that is connected to each pixel PXL, the signal line being a scan line, a data line, a light emission control line, or the like.

The substrate SUB may include a transparent insulation material, and may transmit light. The substrate SUB may be a rigid substrate or a flexible substrate.

One area on the substrate SUB may be provided as a display area DA so that the pixels PXL may be located thereon, and the remaining area on the substrate SUB may be provided as a non-display area NDA. For example, the substrate SUB may include a display area DA including pixel areas in which each pixel PXL is located, and a non-display area NDA located around the display area DA.

Each of the pixels PXL may be provided in the display area DA on the substrate SUB. In some embodiments of the present disclosure, the pixels PXL may be arranged in the display area DA in a stripe or pentile arrangement structure, but the present disclosure is not limited thereto.

Each pixel PXL may include at least one light emitting element LD driven by a corresponding scan signal and data signal. The light emitting element LD may have a size that is as small as a micro-scale or nano-scale, and may be connected in parallel to the light-emitting elements located adjacent to each other, but the present disclosure is not limited thereto. The light emitting element LD may be a light source of each pixel PXL.

Each pixel PXL may include at least one light source driven by a corresponding signal (e.g., a scan signal and a data signal) and/or by a power supply (e.g., a first driving power supply and a second driving power supply). For example, each pixel PXL may include one of the light emitting elements LD shown in FIGS. 1A to 4B, for example, may include at least one ultra-small light emitting element LD having a size on the order of nano-scale to micro-scale. However, the type of light emitting element LD that may be used as the light source of each pixel PXL is not limited thereto.

In some embodiments of the present disclosure, the color, type, and/or number of pixels PXL are not particularly limited. For example, the color of light emitted from each pixel PXL may be variously changed.

The driver may provide a signal and a power supply (e.g., a predetermined signal and a predetermined power supply) to each pixel PXL through a line unit, thereby controlling the driving of the pixel PXL.

The driver may include a scan driver that provides a scan signal to the pixels PXL through the scan line, a light emission driver that provides a light emission control signal to the pixels PXL through the light emission control line, a data driver that provides a data signal to the pixels PXL through the data line, and a timing controller. The timing controller may control the scan driver, the light emission driver, and the data driver.

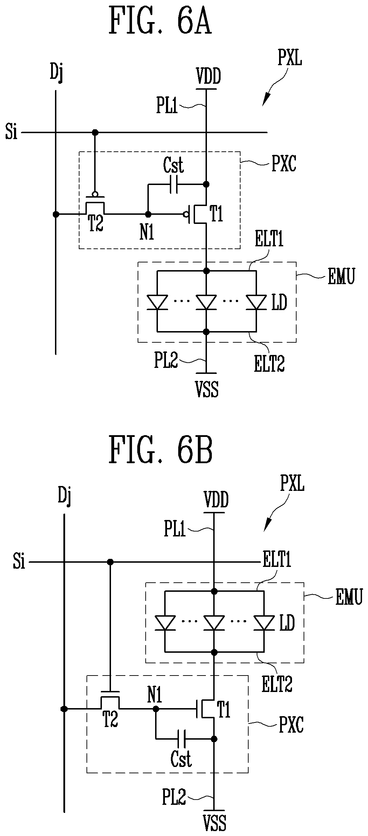

FIGS. 6A to 6E are circuit diagrams each showing an example of a pixel included in a display device of FIG. 5. FIG. 6A to FIG. 6E shows an electrical connection relationship of constituent elements included in the pixel PXL that may be applied to an active display device according to some embodiments. However, the type of the constituent elements included in the pixel PXL is not limited thereto.

In FIGS. 6A to 6E, the area in which the constituent elements are provided, as well as the constituent elements included in each of the pixels shown in FIG. 5, are referred to as the pixel PXL. According to some embodiments, each pixel PXL shown in FIGS. 6A to 6E may be any one of the pixels PXL provided in the display device of FIG. 5, and the pixels PXL may have substantially the same or similar structure to each other.

Referring to FIGS. 6A to 6E, one pixel PXL (hereinafter referred to as 'pixel') may include a light emitting unit EMU that generates light having luminance corresponding to a data signal. In addition, the pixels PXL may further include a pixel driving circuit PXC for driving the light emitting unit EMU.

According to some embodiments, the light emitting unit EMU may include a plurality of the light emitting elements LD that are connected in parallel between a first power line PL1 to which a voltage of the first driving power supply VDD is applied, and a second power line PL2 to which a voltage of the second driving power supply VSS is applied. For example, the light emitting unit EMU may include a first electrode ELT1 (or first alignment electrode) connected to the first driving power supply VDD via the pixel driving circuit PXC and the first power line PL1, a second electrode ELT2 (or second alignment electrode) connected to the second driving power supply VSS through the second power line PL2, and a plurality of light emitting elements LD connected to each other in parallel and arranged in the same direction between the first and second electrodes ELT1 and ELT2. In some embodiments of the present disclosure, the first electrode ELT1 may be an anode, and the second electrode ELT2 may be a cathode.

In some embodiments of the present disclosure, each of the light emitting elements LD included in the light emitting unit EMU may include a first end connected to the first driving power supply VDD through the first electrode ELT1, and a second end connected to the second driving power supply VSS through the second electrode ELT2. The first driving power supply VDD and the second driving power supply VSS may have different voltage potentials from each other. For example, the first driving power supply VDD may be set as a high potential power supply, and the second driving power supply VSS may be set as a low potential power supply. At this time, a potential difference between the first and second driving power supplies VDD and VSS may be set to a threshold voltage of the light emitting elements LD, or higher, during the light emitting period of the pixel PXL.

As described above, each light emitting element LD connected to each other in parallel and in the same direction (e.g., in a forward direction) between the first electrode ELT1 and the second electrode ELT2, to which voltages of different potentials are supplied, may constitute each effective light source. These effective light sources may be grouped to constitute the light emitting unit EMU of the pixel PXL.

The light emitting elements LD of the light emitting unit EMU may emit light with luminance corresponding to a driving current supplied through a corresponding pixel driving circuit PXC. For example, during each frame period, the pixel driving circuit PXC may supply a driving current corresponding to a grayscale value of corresponding frame data to the light emitting unit EMU. The driving current supplied to the light emitting unit EMU may flow through the light emitting elements LD connected in the same direction. Accordingly, while each light emitting element LD emits light with luminance corresponding to the current flowing therein, the light emitting unit EMU may collectively emit light of luminance corresponding to the driving current.

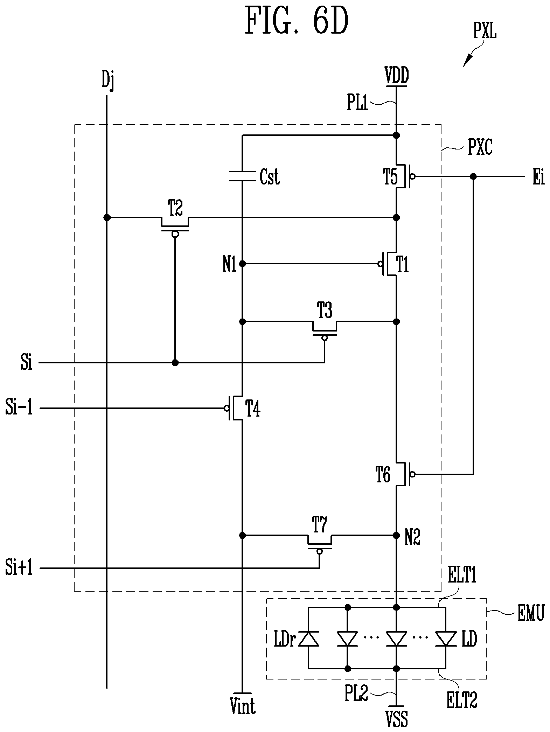

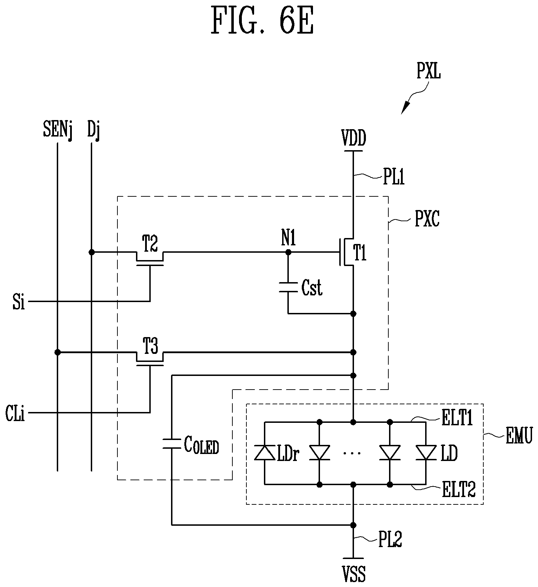

Meanwhile, in FIGS. 6A to 6E, an embodiment in which the light emitting elements LD are connected to each other in the same direction between first and second driving power supplies VDD and VSS is shown, but the present disclosure is not limited thereto. According to some embodiments, the light emitting unit EMU may further include at least one ineffective light source in addition to the light emitting elements LD constituting each effective light source. For example, as shown in FIGS. 6D and 6E, a reverse direction light emitting element LDr may be further connected between the first and second electrodes ELT1 and ELT2 of the light emitting unit EMU. The reverse direction light emitting element LDr may be connected in parallel between the first and second electrodes ELT1 and ELT2 together with the light emitting elements LD constituting the effective light sources, but may be connected between the first and second electrodes ELT1 and ELT2 in the opposite direction to the light emitting elements LD. The reverse direction light emitting element LDr may maintain an inactive state even when a predetermined driving voltage (e.g., a driving voltage of forward direction) is applied between the first and second electrodes ELT1 and ELT2, so that a current does substantially not flow through the reverse direction light emitting element LDr.

The pixel driving circuit PXC may be connected to the scan line Si and to the data line Dj of the corresponding pixel PXL. For example, when the pixel PXL is located in the i-th row (i is natural number) and the j-th column (j is natural number) of the display area DA, the pixel driving circuit PXC of the pixel PXL may be connected to the i-th scan line Si and j-th data line Dj of the display area DA. According to some embodiments, as shown in FIGS. 6A and 6B, the pixel driving circuit PXC may include the first and second transistors T1 and T2 and the storage capacitor Cst. However, the structure of the pixel driving circuit PXC is not limited to that which is shown in FIGS. 6A and 6B.

First, referring to FIG. 6A, the pixel driving circuit PXC may include the first and second transistors T1 and T2 and the storage capacitor Cst.

A first terminal of the second transistor T2 (switching transistor) may be connected to the data line Dj, and a second terminal of the second transistor T2 may be connected to the first node N1. Here, the first terminal and the second terminal of the second transistor T2 may be different terminals. For example, when the first terminal is a source electrode, the second terminal may be a drain electrode. Then, the gate electrode of the second transistor T2 may be connected to the scan line Si.

The second transistor T2 may be turned on when a scan signal of a voltage (e.g., low voltage) at which the second transistor T2 may be turned on is supplied from the scan line Si to electrically connect the data line Dj and the first node N1. At this time, a data signal of the corresponding frame is supplied to the data line Dj, and accordingly, the data signal is transferred to the first node N1. The data signal transferred to the first node N1 is charged to the storage capacitor Cst.

The first terminal of the first transistor T1 (or driving transistor) may be connected to the first driving power supply VDD, and the second terminal of the first transistor T1 may be electrically connected to the first electrode ELT1 of each of the light emitting elements LD. The gate electrode of the first transistor T1 may be connected to the first node N1. The first transistor T1 controls an amount of a driving current supplied to the light emitting elements LD in response to the voltage of the first node N1.

One electrode of the storage capacitor Cst may be connected to the first driving power supply VDD, and the other electrode of the storage capacitor Cst may be connected to the first node N1. The storage capacitor Cst may charge the voltage corresponding to the data signal supplied to the first node N1, and may maintain the charged voltage until the data signal of the next frame is supplied.

Each of FIGS. 6A and 6B shows the pixel driving circuit PXC including the second transistor T2 for transferring the data signal into the pixel PXL, the storage capacitor Cst for storing the data signal, and the first transistor T1 for supplying the driving current corresponding to the data signal to the light emitting elements LD.

However, the present disclosure is not limited thereto, and the structure of the pixel driving circuit PXC may be variously changed. For example, the pixel driving circuit PXC may further include at least one transistor element, such as a transistor element for compensating for the threshold voltage of the first transistor T1, a transistor element for initializing the first node N1, and/or a transistor element for controlling the light emitting time of the light emitting element LD, and the like, and/or may further include other circuit elements, such as a boosting capacitor for boosting a voltage of the first node N1, and the like.

In addition, in FIG. 6A, transistors included in the pixel driving circuit PXC, for example first and second transistors T1 and T2, are all shown to be P-type transistors, but the present disclosure is not limited thereto. That is, at least one of the first and second transistors T1 and T2 included in the pixel driving circuit PXC may be changed to an N-type transistor in other embodiments.

Next, referring to FIGS. 6A to 6B, the first and second transistors T1 and T2 according to some embodiments of the present disclosure may be implemented as an N-type transistor. The pixel driving circuit PXC shown in FIG. 6B may have a configuration or operation that is generally similar to the pixel driving circuit PXC of FIG. 6A, except for changing a connection position of some constituent elements due to a change in transistor type. Therefore, a brief description thereof is provided below.

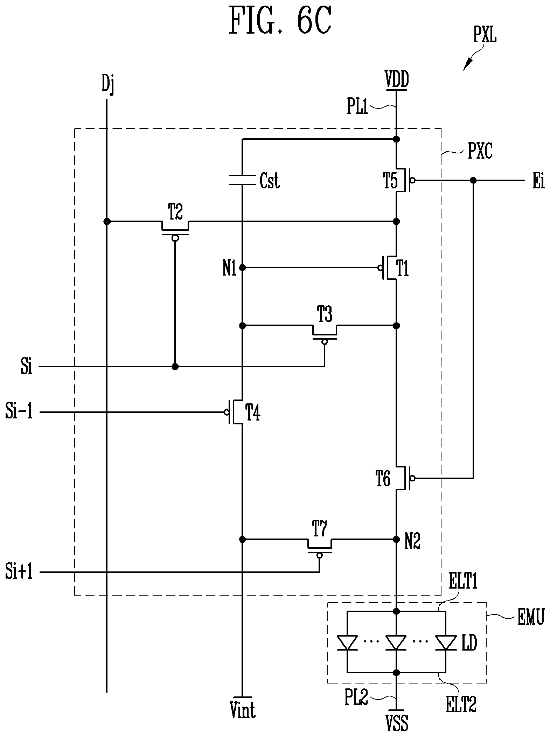

In some embodiments of the present disclosure, the pixel driving circuit PXC shown in FIG. 6B may include the first and second transistors T1 and T2 as N-type transistors, and may also include the storage capacitor Cst. When the first and second transistors T1 and T2 are N-type transistors, the light emitting unit EMU may be connected between the first driving power supply VDD and the pixel driving circuit PXC for stabilization of the storage capacitor Cst, which charges the voltage corresponding to the data signal supplied to the first node N1. However, the present disclosure is not limited thereto, and according to some embodiments, the light emitting unit EMU shown in FIG. 6A may be connected between the pixel driving circuit PXC and the second driving power supply VSS. In some embodiments of the present disclosure, the configuration of the pixel driving circuit PXC is not limited to that which is shown in FIGS. 6A and 6B. For example, the pixel driving circuit PXC may be configured as shown in FIGS. 6C and 6D.

The pixel driving circuit PXC, as shown in FIGS. 6C and 6D, may be connected to the scan line Si and the data line Dj of the pixel PXL. For example, when the pixel PXL is located in the i-th row and j-th column of the display area DA, the pixel driving circuit PXC of the pixel PXL may be connected to the i-th scan line Si and j-th data line Dj of the display area DA.

Further, according to some embodiments, the pixel driving circuit PXC may be further connected to at least one other scan line. For example, the pixel PXL located on the i-th row of the display area DA may be further connected to the i-1-th scan line Si-1 and/or the i+1-th scan line Si+1. In addition, according to some embodiments, the pixel driving circuit PXC may be further connected to a third power supply in addition to the first and second driving power supplies VDD and VSS. For example, the pixel driving circuit PXC may be connected to an initialization power supply Vint.

The pixel driving circuit PXC may include first to seventh transistors T1 to T7 and the storage capacitor Cst.

One electrode (for example, the source electrode) of the first transistor T1 (or driving transistor) may be connected to the first driving power supply VDD via the fifth transistor T5, and another electrode of the first transistor T1 (for example, the drain electrode) may be connected to one end of the light emitting element LD via the sixth transistor T6. Further, the gate electrode of the first transistor T1 may be connected to the first node N1. The first transistor T1 controls the driving current flowing between the first driving power supply VDD and the second driving power supply VSS via light emitting elements LD in response to the voltage of the first node N1.

The second transistor T2 (or switching transistor) may be connected between the j-th data line Dj connected to the pixel PXL and the source electrode of the first transistor T1. Further, the gate electrode of the second transistor T2 may be connected to the i-th scan line Si connected to the pixel PXL. The second transistor T2 may be turned on when a scan signal of a gate-on voltage (e.g., low voltage) is supplied from the i-th scan line Si to electrically connect the j-th data line Dj to the source electrode of the first transistor T1. Therefore, when the second transistor T2 is turned on, the data signal supplied from the j-th data line Dj is transferred to the first transistor T1.

The third transistor T3 may be connected between the drain electrode of the first transistor T1 and the first node N1. Further, the gate electrode of the third transistor T3 may be connected to the i-th scan line Si. The third transistor T3 may be turned on when a scan signal of a gate-on voltage is supplied from the i-th scan line Si to electrically connect the drain electrode of the first transistor T1 and the first node N1.

The fourth transistor T4 may be connected between the first node N1 and an initialization power line to which the initialization power supply Vint is applied. Further, the gate electrode of the fourth transistor T4 may be connected to the previous scan line, for example, the i-1-th scan line Si-1. The fourth transistor T4 may be turned on when a scan signal of the gate-on voltage is supplied from the i-1-th scan line Si-1 to transfer the voltage of the initialization power supply Vint to the first node N1. Here, the initialization power supply Vint may have a voltage that is less than or about equal to the lowest voltage of the data signal.

The fifth transistor T5 may be connected between the first driving power supply VDD and the first transistor T1. Further, the gate electrode of the fifth transistor T5 may be connected to a corresponding light emission control line, for example, the i-th light emission control line Ei. The fifth transistor T5 may be turned off when a light emission control signal of a gate-off voltage is supplied from the i-th light emission control line Ei, and may be turned on in other cases.

The sixth transistor T6 may be connected between the first transistor T1 and one end of the light emitting elements LD (or a second node N2). Further, the gate electrode of the sixth transistor T6 may be connected to the i-th light emission control line Ei. The sixth transistor T6 may be turned off when a light emission control signal of a gate-off voltage is supplied from the i-th light emission control line Ei, and may be turned on in other cases.

The seventh transistor T7 may be connected between one end of the light emitting elements LD and the initializing power line. Further, the gate electrode of the seventh transistor T7 may be connected to one of the scan lines in the next stage, for example, the i+1-th scan line Si+1. The seventh transistor T7 may be turned on when a scan signal of the gate-on voltage is supplied from the i+1-th scan line Si+1, and may supply the voltage of the initialization power supply Vint to one end of the light emitting elements LD.

The storage capacitor Cst may be connected between the first driving power supply VDD and the first node N1. The storage capacitor Cst may store a data signal supplied to the first node N1 during each frame period and a voltage corresponding to the threshold voltage of the first transistor T1.

In FIGS. 6C and 6D, transistors included in the pixel driving circuit PXC, for example, first to seventh transistors T1 to T7, are all shown to be P-type transistors, but the present disclosure is not limited thereto. For example, at least one of the first to seventh transistors T1 to T7 may be changed to an N-type transistor in other embodiments.

In some embodiments of the present disclosure, the configuration of the pixel driving circuit PXC is not limited to that which is shown in FIGS. 6A to 6D. For example, the pixel driving circuit PXC may be configured as shown in FIG. 6E.

The pixel driving circuit PXC, as shown in FIG. 6E, may be further connected to a control line CLi and to a sensing line SENj. For example, the pixel driving circuit PXC of the pixel PXL located in the i-th row and j-th column of the display area DA may be connected to the i-th control line CLi and j-th sensing line SENj of the display area DA. The pixel driving circuit PXC described above may further include a third transistor T3 in addition to the first and second transistors T1 and T2 shown in FIGS. 6A and 6B. According to some embodiments, the pixel driving circuit PXC may further include a capacitor C_{OLED} formed between one terminal of the first transistor T1 and the second power line PL2.

The third transistor T3 may be connected between the first transistor T1 and the sensing line SENj. For example, one electrode of the third transistor T3 may be connected to one terminal (e.g., to the source electrode) of the first transistor T1 connected to the first electrode ELT1, and another electrode of the third transistor T3 may be connected to the sensing line SENj. On the other hand, when the sensing line SENj is omitted, the other electrode of the third transistor T3 may be connected to the data line Dj.

According to some embodiments, the gate electrode of the third transistor T3 may be connected to the control line CLi. On the other hand, when the control line CLi is omitted, the gate electrode of the third transistor T3 may be connected to the scan line Si. The third transistor T3 may be turned on by a control signal of a gate-on voltage (e.g., high level) supplied from the control line CLi during a predetermined sensing period to electrically connect the sensing line SENj and the first transistor T1.

According to some embodiments, the sensing period may be a period for extracting characteristic information (e.g., a threshold voltage of first transistor T1) of each of the pixels PXL located on the display area DA. During the sensing period described above, the first transistor T1 may be turned on by supplying a voltage (e.g., a predetermined reference voltage at which the first transistor T1 may be turned on) to the first node N1 through the data line Dj and the second transistor T2, or by connecting each pixel PXL to a current source, and the like. In addition, the first transistor T1 may be connected to the sensing line SENj by supplying a control signal of a gate-on voltage to the third transistor T3 to turn on the third transistor T3. Accordingly, the characteristic information of each pixel PXL including the threshold voltage of the first transistor T1 may be extracted through the sensing line SENj described above. The extracted characteristic information may be used to convert image data so that a characteristic deviation between the pixels PXL may be compensated.

Meanwhile, in FIG. 6E, embodiments in which the first to third transistors T1 to T3 are all N-type transistors are shown, but the present disclosure is not limited thereto. For example, at least one of the first to third transistors T1 to T3 described above may be changed to a P-type transistor in other embodiments. In addition, in FIG. 6E, an example in which the light emitting unit EMU is connected between the pixel driving circuit PXC and the second driving power supply VSS is disclosed, but the light emitting unit EMU may be connected between the first driving power supply VDD and the pixel driving circuit PXC.

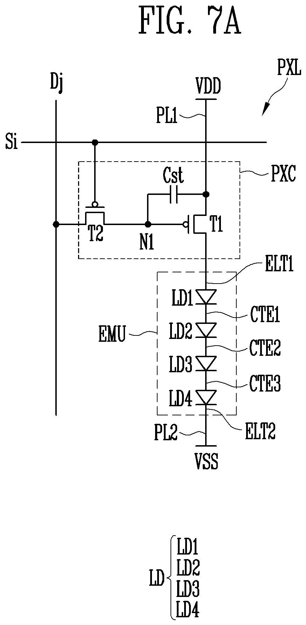

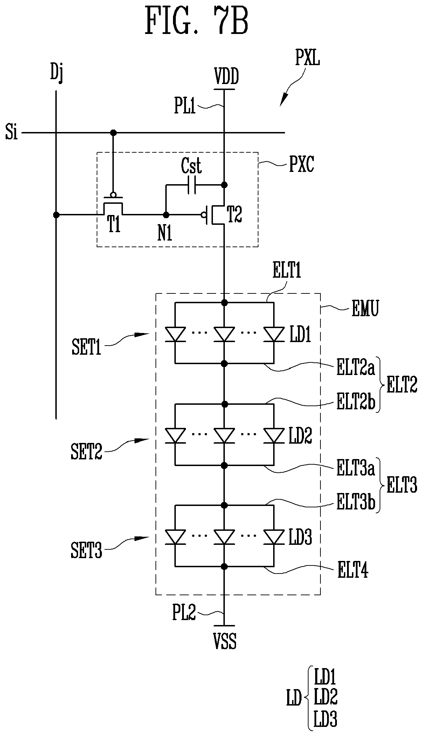

In addition, In FIGS. 6A to 6E, it is shown that the light emitting elements LD, which constitute each light emitting unit EMU, are all connected in parallel, but the present disclosure is not limited thereto. According to some embodiments, the light emitting unit EMU may be configured to include at least one serial set including a plurality of light emitting elements LD connected in parallel to each other. That is, the light emitting unit EMU may be configured as an in-series/in-parallel mixed structure. The embodiment described above will be described later with reference to FIGS. 7A and 7B.

The structure of the pixel PXL that may be applied to the present disclosure is not limited to the embodiments shown in FIGS. 6A to 6E, and the corresponding pixel may have various structures. In addition, in other embodiments of the present disclosure, each pixel PXL may be formed inside a passive light emitting display device. In this case, the pixel driving circuit PXC may be omitted, and both ends of the light emitting elements LD included in the light emitting unit EMU may be directly connected to scan lines Si-1, Si, and Si+1, a data line Dj, a first power line PL1 to which the first driving power supply VDD is applied, a second power line PL2 to which the second driving power supply VSS is applied, and/or a predetermined control line.

FIGS. 7A to 7B are circuit diagrams showing other examples of a pixel included in a display device of FIG. 5. In FIGS. 7A and 7B, the light emitting unit EMU of each pixel PXL may be configured to include a plurality of serial sets connected to each other continuously. To avoid duplicate descriptions in describing the embodiments of FIGS. 7A and 7B, repeated descriptions of the configuration(s) that are similar to, or the same as, the embodiments of FIGS. 6A to 6E (e.g., the pixel driving circuit PXC) will be omitted.

First, referring to FIG. 7A, the light emitting unit EMU may include a plurality of light emitting elements connected in series with each other. For example, the light emitting unit EMU may include a first light emitting element LD1, a second light emitting element LD2, a third light emitting element LD3, and a fourth light emitting element LD4 that are serially connected in a forward direction between the first driving power supply VDD and the second driving power supply VSS to constitute an effective light source. In the following example, at least one light emitting element of the first to fourth light emitting elements LD1 to LD4 is arbitrarily referred to as a light emitting element LD or light emitting elements LD, or the first to fourth light emitting elements LD1 to LD4 are generally referred to as a light emitting element LD or light emitting elements LD.

One end (e.g., the second semiconductor layer) of the first light emitting element LD1 may be connected to the first driving power supply VDD through the first electrode ELT1, and the other end (e.g., the first semiconductor layer) of the first light emitting element LD1 may be connected to one end (e.g., the second semiconductor layer) of the second light emitting element LD2 through a first middle electrode CTE1 that is connected between first and second serial sets (e.g., between the first and second light emitting elements LD1 and LD2).

One end of the second light emitting element LD2 may be connected to the first middle electrode CTE1, and the other end (e.g., the first semiconductor layer) thereof may be connected to one end (e.g., the second semiconductor layer) of the third light emitting element LD3 through the second middle electrode CTE2 connected between second and third serial sets (e.g., between the second and third light emitting elements LD2 and LD3).

One end of the third light emitting element LD3 may be connected to the second middle electrode CTE2, and the other end (e.g., the first semiconductor layer) thereof may be connected to one end (e.g., the second semiconductor layer) of the fourth light emitting element LD4 through the third middle electrode CTE3 connected between third and fourth serial sets (e.g., between the third and fourth light emitting elements LD3 and LD4).

One end of the fourth light emitting element LD4 may be connected to the third middle electrode CTE3, and the other end (e.g., the first semiconductor layer) thereof may be connected to the second driving power supply VSS through the second electrode ELT2.

As described above, the first to fourth light emitting elements LD1 to LD4 may be connected in series between the first and second electrodes ELT1 and ELT2 of the light emitting unit EMU of the pixel PXL.

A voltage applied between the first and second electrodes ELT1 and ELT2 may be increased, and a size of a driving current flowing through the light emitting unit EMU may be reduced, in the light emitting unit EMU having a structure in which light emitting elements LD are connected in series (e.g., as compared to the light emitting unit EMU having a structure in which light emitting elements LD are connected in parallel). Accordingly, when the light emitting unit EMU of each pixel PXL is configured as a serial structure, power consumption of the display device may be reduced.

According to some embodiments, at least one serial set may be provided in a form including a plurality of light emitting elements LD connected in parallel with each other. In this case, the light emitting unit EMU of each pixel PXL may be configured as an in-series/in-parallel mixed structure. For example, the light emitting unit EMU may be configured as shown in FIG. 7B.

Next, referring to FIG. 7B, the light emitting unit EMU of the pixel PXL may include a plurality of serial sets (e.g., a plurality of sets connected serially, each set including a plurality of light emitting elements connected in parallel), the serial sets being connected sequentially between first and second driving power supplies VDD and VSS. Further, each serial set may include at least one light emitting element LD connected in a forward direction between two electrodes constituting an electrode pair of the corresponding serial set. For example, the light emitting unit EMU may include first to third serial sets SET1 to SET3 sequentially connected to the first and second driving power supplies VDD and VSS. Each of the first to third serial sets SET1 to SET3 may include two electrodes (e.g., ELT1 and ELT2a, ELT2b and ELT3a, ELT3b and ELT4) constituting the electrode pair of the corresponding serial set, and a plurality of light emitting elements LD that are connected in parallel in a forward direction, for example, in the same direction between two electrodes (e.g., between ELT1 and ELT2a, between ELT2b and ELT3a, or between ELT3b and ELT4).

The first serial set SET1 may include the first electrode ELT1 and the 2a-th electrode ELT2a as an electrode pair included in the light emitting unit EMU, and may include at least one first light emitting element LD1 connected between the first electrode ELT1 and the 2a-th electrode ELT2a. For example, the first serial set SET1 may include the first electrode ELT1 connected to the first driving power supply VDD via the pixel driving circuit PXC, the 2a-th electrode ELT2a connected to the second driving power supply VSS, and a plurality of first light emitting elements LD1 connected between the first electrode ELT1 and the 2a-th electrode ELT2a. One end (e.g., the second semiconductor layer) of each first light emitting element LD1 may be electrically connected to the first electrode ELT1 of the first serial set SET1, and the other end (e.g., the first semiconductor layer) thereof may be electrically connected to the 2a-th electrode ELT2a of the first serial set SET1. The first light emitting elements LD1 may be connected in parallel between the first electrode ELT1 and the 2a-th electrode ELT2a of the first serial set SET1, and may be connected in the same direction (e.g., in a forward direction) between the first electrode ELT1 and the 2a-th electrode ELT2a.

According to some embodiments, at least one reverse direction light emitting element LDr (see FIG. 6E) may be further connected in the first serial set SET1. The reverse direction light emitting element LDr may be connected in parallel between the first electrode ELT1 and the 2a-th electrode ELT2a together with the first light emitting elements LD1 constituting the effective light sources, but may be connected between the first electrode ELT1 and the 2a-th electrode ELT2a in the opposite direction to the first light emitting elements LD1. The reverse direction light emitting element LDr may maintain an inactive state even when a driving voltage (e.g., a driving voltage of forward direction) is applied between the first and 2a-th electrodes ELT1 and ELT2a, so that substantially no current flows through the reverse direction light emitting element LDr.

The second serial set SET2 may include the 2b-th electrode ELT2b and the 3a-th electrode ELT3a as an electrode pair included in the light emitting unit EMU, and may include at least one second light emitting element LD2 connected between the 2b-th electrode ELT2b and the 3a-th electrode ELT3a. For example, the second serial set SET2 may include the 2b-th electrode ELT2b connected to the first driving power supply VDD via the pixel driving circuit PXC and the first serial set SET1, the 3a-th electrode ELT3a connected to the second driving power supply VSS, and a plurality of second light emitting elements LD2 connected between the 2b-th electrode ELT2b and the 3a-th electrode ELT3a. One end (e.g., the second semiconductor layer) of each second light emitting element LD2 may be electrically connected to the 2b-th electrode ELT2b of the second serial set SET2, and the other end (e.g., the first semiconductor layer) thereof may be electrically connected to the 3a-th electrode ELT3a of the second serial set SET2. The second light emitting elements LD2 may be connected in parallel between the 2b-th and 3a-th electrodes ELT2b and ELT3a of the second serial set SET2, and may be connected in the same direction (e.g., in the forward direction) between the first and second driving power supplies VDD and VSS through the 2b-th and 3a-th electrodes ELT2b and ELT3a.

According to some embodiments, at least one reverse direction light emitting element LDr (see FIG. 6E) may be further connected between the 2b-th and 3a-th electrodes ELT2b and ELT3a. The reverse direction light emitting elements LDr may be connected in parallel between the 2b-th and 3a-th electrodes ELT2b and ELT3a together with the second light emitting elements LD2 constituting the effective light sources, but may be connected between the 2b-th and 3a-th electrodes ELT2b and ELT3a in the opposite direction as the second light emitting elements LD2.

In some embodiments of the present disclosure, the 2a-th electrode ELT2a of the first serial set SET1 and the 2b-th electrode ELT2b of the second serial set SET2 may be integrally provided and connected to each other. That is, the 2a-th electrode ELT2a of the first serial set SET1 and the 2b-th electrode ELT2b of the second serial set SET2 may constitute the second electrode ELT2 electrically connecting the first serial set SET1 and the second serial set SET2. As described above, when the 2a-th electrode ELT2a of the first serial set SET1 and the 2b-th electrode ELT2b of the second serial set SET2 are integrally provided, the 2a-th electrode ELT2a and the 2b-th electrode ELT2b may be thought of as different areas or portions of the second electrode ELT2.

The third serial set SET3 may include the 3b-th electrode ELT3b and the fourth electrode ELT4 as an electrode pair included in the light emitting unit EMU, and may include at least one third light emitting element LD3 connected to the 3b-th electrode ELT3b and the fourth electrode ELT4. For example, the third serial set SET3 may include the 3b-th electrode ELT3b connected to the first driving power supply VDD via the pixel driving circuit PXC and previous serial sets (e.g., first and second serial sets SET1 and SET2), the fourth electrode ELT4 connected to the second driving power supply VSS, and a plurality of third light emitting elements LD3 connected between the 3b-th electrode ELT3b and the fourth electrode ELT4. One end (e.g., the second semiconductor layer) of each third light emitting element LD3 may be electrically connected to the 3b-th electrode ELT3b of the third serial set SET3, and the other end (e.g., the first semiconductor layer) thereof may be electrically connected to the fourth electrode ELT4 of the third serial set SET3. The third light emitting elements LD3 may be connected in parallel between the 3b-th electrode ELT3b and the fourth electrode ELT4 of the third serial set SET3, and may be connected in the same direction (e.g., in the forward direction) between the first and second driving power supplies VDD and VSS through the 3b-th electrode ELT3b and the fourth electrode ELT4.

According to some embodiments, at least one reverse direction light emitting element LDr (see FIG. 6E) may be further connected between the 3b-th and fourth electrodes ELT3b and ELT4. The reverse direction light emitting elements LDr may be connected in parallel between the 3b-th and fourth electrodes ELT3b and ELT4 together with the third light emitting elements LD3 constituting the effective light sources, but may be connected between the 3b-th and fourth electrodes ELT3b and ELT4 in the opposite direction to the third light emitting elements LD3.

In some embodiments of the present disclosure, the 3a-th electrode ELT3a of the second serial set SET2 and the 3b-th electrode ELT3b of the third serial set SET3 may be integrally provided and connected to each other. That is, the 3a-th electrode ELT3a of the second serial set SET2 and the 3b-th electrode ELT3b of the third serial set SET3 may constitute the third electrode ELT3 electrically connecting the second serial set SET2 and the third serial set SET3. As described above, when the 3a-th electrode ELT3a of the second serial set SET2 and the 3b-th electrode ELT3b of the third serial set SET3 are integrally provided, the 3a-th electrode ELT3a and the 3b-th electrode ELT3b may be different respective portions or areas of the third electrode E LT3.

In the embodiment described above, the first electrode ELT1 of the first serial set SET1 may be the anode of the light emitting unit EMU of each pixel PXL, and the fourth electrode ELT4 of the third serial set SET3 may be a cathode of the light emitting unit EMU.

As described above, the light emitting unit EMU of the pixel PXL including the light emitting elements LD connected as an in-series/in-parallel mixed structure may easily adjust the driving current/voltage condition according to the applied product specifications.

In particular, the light emitting unit EMU of the pixels PXL including the light emitting elements LD connected as an in-series/in-parallel mixed structure may reduce the driving current when compared to the light emitting unit EMU of the structure in which the light emitting elements LD are entirely connected in parallel. In addition, the light emitting unit EMU of the pixels PXL including the light emitting elements LD connected to each other in an in-series/in-parallel mixed structure may reduce the driving voltage applied to both ends of the light emitting unit EMU when compared to the light emitting unit EMU of the structure in which the light emitting elements LD are all connected in series. In addition, in a case where all the light emitting elements LD are connected only in series, when at least one of the light emitting elements LD connected in series is not completely connected in the forward direction (e.g., is the reverse direction light emitting element LDr), the path through which the driving current can flow in the pixel PXL is blocked, thereby causing a dark spot defect. On the other hand, in a case where the light emitting elements LD are connected in the in-series/in-parallel mixed structure, even though some light emitting elements LD are not connected in the forward direction, or include the reverse direction light emitting element LDr, in one or more of the serial sets, or even though a defect occurs in one or more light emitting elements LD, the driving current still may flow through another light emitting element LD in the corresponding serial set. Accordingly, the defect of the pixel PXL may be prevented or reduced.

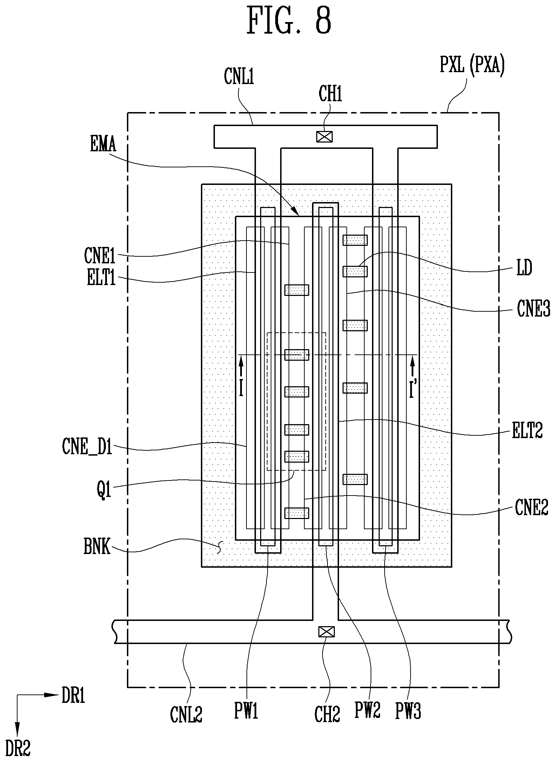

FIG. 8 is a top plan view showing an example of a pixel included in a display device of FIG. 5.

Referring to FIG. 8, the pixel PXL (or pixel area PXA) may include a light emitting area EMA in which at least a pair of a first electrode ELT1 and a second electrode ELT2 are located, and in which at least one light emitting element LD that is connected between and the first and second electrodes ELT1 and ELT2 is located. According to some embodiments, the light emitting area EMA may be defined by a bank BNK surrounding the light emitting area EMA. The bank BNK may function as a dam structure that prevents a solution, in which the light emitting elements LD are mixed, from flowing into the light emitting area EMA of adjacent pixel PXL, or that controls the supply of an amount of solution to each light emitting area EMA when supplying the light emitting elements LD to the light emitting area EMA.

The first and second electrodes ELT1 and ELT2 may extend in the second direction DR2, and may be spaced apart from each other in the first direction DR1.

According to some embodiments, each of the first and second electrodes ELT1 and ELT2 may have a single-layer or multi-layer structure. For example, the first electrode ELT1 may have a multi-layer structure including a first reflective electrode and a first conductive capping layer, and the second electrode may have a multi-layer structure including a second reflective electrode and a second conductive capping layer.

According to some embodiments, the first electrode ELT1 may be connected to a first connecting electrode CNL1. The first electrode ELT1 may be integrally connected to the first connecting electrode CNL1. For example, the first connecting electrode CNL1 may extend in the first direction DR1, and the first electrode ELT1 may be formed by branching at least one branch from the first connecting electrode CNL1. When the first electrode ELT1 and the first connecting electrode CNL1 are integrally formed, the first connecting electrode CNL1 may be regarded as one region of the first electrode ELT1. However, the present disclosure is not limited thereto. For example, in other embodiments of the present disclosure, the first electrode ELT1 and the first connecting electrode CNL1 may be formed separately from each other to be electrically connected to each other through at least one contact hole or via hole.

According to some embodiments, the first connecting electrode CNL1 may have a single-layer or multi-layer structure. As an example, the first connecting electrode CNL1 may include a first sub-connecting electrode integrally connected to the first reflective electrode, and a second sub-connecting electrode integrally connected to the first conductive capping layer. According to some embodiments, the first connecting electrode CNL1 may have the same cross-section structure (or stacked structure) as the first electrode ELT1, but is not limited thereto.

The first electrode ELT1 and the first connecting electrode CNL1 may be connected to the pixel driving circuit PXC of the pixel PXL (e.g., the pixel driving circuit PXC shown in any one of FIGS. 6A to 6C) through a first contact hole CH1.

According to some embodiments, the first contact hole CH1 may be located outside the light emitting area EMA of the pixel PXL. For example, the first contact hole CH1 may be located around the corresponding light emitting area EMA while overlapping with the bank BNK. In this case, because the first contact hole CH1 is covered by the bank BNK, it is possible to reduce or prevent reflection of a pattern in the light emitting area EMA. However, the present disclosure is not limited thereto. For example, in other embodiments of the present disclosure, at least one first contact hole CH1 may be located inside of the light emitting area EMA.

According to some embodiments, the pixel driving circuit PXC may be located under the light emitting elements LD located in the corresponding pixel area PXA. For example, each pixel driving circuit PXC may be formed in a pixel circuit layer (or circuit element layer including a circuit element such as a transistor) under the light emitting elements LD to be connected to the first electrode ELT1 through the first contact hole CH1.

According to some embodiments, the second electrode ELT2 may be connected to the second connecting electrode CNL2. For example, the second electrode ELT2 may be integrally connected to the second connecting electrode CNL2. For example, the second connecting electrode CNL2 may extend in the first direction DR1, and the second electrode ELT2 may be formed by branching at least one branch from the second connecting electrode CNL2. When the second electrode ELT2 and the second connecting electrode CNL2 are integrally formed, the second connecting electrode CNL2 may be regarded as one region of the second electrode ELT2. However, the present disclosure is not limited thereto. For example, in other embodiments of the present disclosure, the second electrode ELT2 and the second connecting electrode CNL2 are formed separately from each other to be electrically connected to each other through at least one contact hole or via hole.

According to some embodiments, similar to the first connecting electrode CNL1, the second connecting electrode CNL2 may have a single-layer or multi-layer structure.

According to some embodiments, the second electrode ELT2 and the second connecting electrode CNL2 may be connected to the second driving power supply VSS (see FIG. 6A). For example, the second electrode ELT2 and the second connecting electrode CNL2 may be connected to the second driving power supply VSS through the second contact hole CH2 and through the second power line PL2 (see FIG. 6A) connected thereto.

According to some embodiments, the second contact hole CH2 may be located outside of the light emitting area EMA of the pixel PXL. For example, the second contact hole CH2 may be located around the corresponding light emitting area EMA while overlapping the bank BNK. In this case, because the second contact hole CH2 is covered by the bank BNK, it is possible to reduce or prevent reflection of a pattern in the light emitting area EMA. However, the present disclosure is not limited thereto. For example, in other embodiments of the present disclosure, at least one second contact hole CH2 may be located inside the light emitting area EMA.

The first bank pattern PW1 (and third bank pattern PW3) is located under the first electrode ELT1 while overlapping with one region of the first electrode ELT1, and the second bank pattern PW2 is located under the second electrode ELT2 while overlapping with one region of the second electrode ELT2. The first and second bank patterns PW1 and PW2 are spaced apart from each other in the light emitting area EMA, and may protrude from a respective region(s) of the first and second electrodes ELT1 and ELT2 in the upper direction. For example, the first electrode ELT1 may be located on the first bank pattern PW1 to protrude in a height direction (or in a thickness direction) of the substrate SUB (see FIG. 5) from the first bank pattern PW1, and the second electrode ELT2 may be located on the second bank pattern PW2 to protrude in the height direction of the substrate SUB (see FIG. 5) from the second bank pattern PW2.

According to the invention, at least one light emitting element LD, for example a plurality of light emitting elements LD, is arranged between the first and second electrodes ELT1 and ELT2 of the pixel PXL. In the light emitting area EMA located so that the first electrode ELT1 and the second electrode ELT2 may face each other, a plurality of light emitting elements LD may be connected in parallel.

Meanwhile, in FIG. 8, the light emitting elements LD are shown to extend in the first direction DR1 between the first and second electrodes ELT1 and ELT2, for example in a horizontal direction, but the arrangement direction of light emitting elements LD is not limited thereto. For example, at least one of the light emitting elements LD may be arranged in a diagonal direction.

Each of the light emitting elements LD may be electrically connected between the first and second electrodes ELT1 and ELT2 of the pixel PXL. For example, a first end of each of the light emitting elements LD may be electrically connected to the first electrode ELT1, and a second end of each of the light emitting elements LD may be electrically connected to the second electrode ELT2.

In some embodiments, the first end of each of the light emitting elements LD may be located not directly on the first electrode ELT1, but may be instead electrically connected to the first electrode ELT1 through at least one contact electrode, for example through a first contact electrode CNE1 (or third electrode). However, the present disclosure is not limited thereto. For example, in other embodiments of the present disclosure, the first end of the light emitting elements LD may directly contact the first electrode ELT1 to be electrically connected to the first electrode ELT1.

Similarly, the second end of each of the light emitting elements LD may be located not directly on the second electrode ELT2, but may be instead electrically connected to the second electrode ELT2 through at least one contact electrode (e.g., a second contact electrode CNE2 (or fourth electrode)). However, the present disclosure is not limited thereto. For example, in other embodiments of the present disclosure, the second end of each of the light emitting elements LD may directly contact the second electrode ELT2 to be electrically connected to the second electrode E LT2.

According to some embodiments, each of the light emitting elements LD may be a light emitting diode having an ultra-small size (e.g., nano-scale to micro-scale) using the material of an inorganic crystal structure. For example, each of the light emitting elements LD may be an ultra-small light emitting diode having the size of a nano-scale to micro-scale as shown in any one of FIGS. 1A to 4B.

According to some embodiments, the light emitting elements LD may be prepared in a form to be dispersed in a solution (e.g., a predetermined solution), and may be supplied to the light emitting area EMA of each pixel PXL by using an inkjet printing method or a slit coating method. For example, the light emitting elements LD may be mixed with a volatile solvent to be supplied to the light emitting area EMA. At this time, when a voltage (e.g., a predetermined voltage) is supplied to the first and second electrodes ELT1 and ELT2 of the pixel PXL, an electric field is formed between the first and second electrodes ELT1 and ELT2, and the light emitting elements LD are self-aligned between the first and second electrodes ELT1 and ELT2. After the light emitting elements LD are aligned, the solvent may be volatilized or removed by using a suitable method, thereby stably arranging the light emitting elements LD between the first and second electrodes ELT1 and ELT2. In addition, by forming the first contact electrode CNE1 and second contact electrode CNE2 on the first end and second end of the light emitting elements LD, respectively, the light emitting elements LD may be stably connected between the first and second electrodes ELT1 and ELT2.

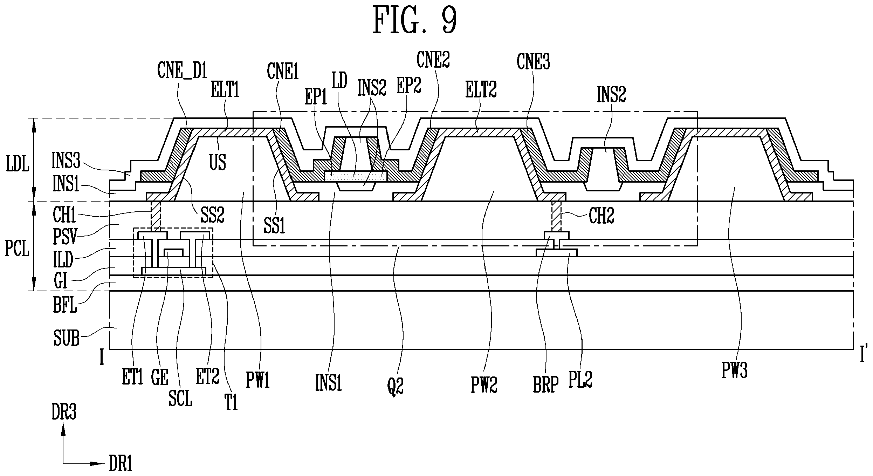

According to some embodiments, the first contact electrode CNE1 may be formed on the first end of the light emitting elements LD and on least one region of the first electrode ELT1 corresponding thereto, so that the first end (e.g., first end EP1 shown in FIG. 9) of the light emitting elements LD may be physically and/or electrically connected to the first electrode ELT1. Similarly, the second contact electrode CNE2 may be formed on the second end of the light emitting elements LD and on at least one region of the second electrode ELT2 corresponding thereto, so that the second end (e.g., second end EP2 shown in FIG. 9) of the light emitting elements LD may be physically and/or electrically connected to the second electrode ELT2.

The light emitting elements LD located in the pixel area PXA may be grouped to constitute a light source of the corresponding pixel PXL. For example, when the driving current flows in at least one pixel PXL during each frame period, the light emitting elements LD connected in a forward direction between the first and second electrodes ELT1 and ELT2 of the pixel PXL may emit light of luminance corresponding to the driving current.

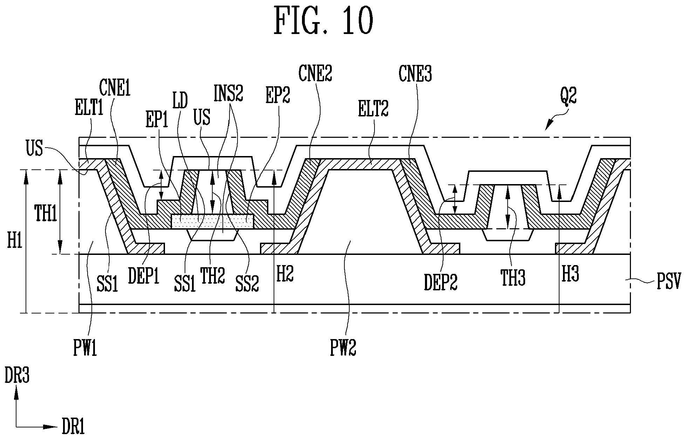

FIG. 9 is a cross-sectional view showing an example of a pixel taken along the line I-I' of FIG. 8. FIG. 10 is an enlarged cross-sectional view of the area Q2 of FIG. 9.

First, referring to FIGS. 8 and 9, a pixel circuit layer PCL and a light emitting element layer LDL may be sequentially located on the substrate SUB (or base layer). For example, the pixel circuit layer PCL may be formed on one surface of the substrate SUB, and the light emitting element layer LDL may be formed on one surface of the substrate SUB on which the pixel circuit layer PCL is formed. According to some embodiments, the pixel circuit layer PCL and the light emitting element layer LDL may be entirely formed on the display area DA (see FIG. 5) of the display device.

According to some embodiments, the pixel circuit layer PCL may include circuit elements constituting the pixel driving circuit PXC (see FIGS. 6A to 7B) of the pixel PXL.

The light emitting element layer LDL may include the light emitting element LD of the pixel PXL.

For example, the pixel circuit layer PCL may include the first transistor T1 shown in FIGS. 6A to 7B. In addition, in some embodiments, the pixel circuit layer PCL also may include the storage capacitor Cst shown in FIGS. 6A to 7B, various signal lines (e.g., scan line Si and data line Dj shown in FIGS. 6A to 7B) connected to the pixel driving circuit PXC, and various power lines (e.g., the first power line PL1 and the second power line PL2) connected to the pixel driving circuit PXC and/or the light emitting element LD.

In addition, the pixel circuit layer PCL includes a plurality of insulation layers. For example, the pixel circuit layer PCL may include a buffer layer BFL, a gate insulation layer GI (or gate insulation film), an interlayer insulation layer ILD (or interlayer insulation film), and a passivation layer PSV (or protective layer), which are sequentially stacked on one surface of the substrate SUB.

According to some embodiments, the buffer layer BFL may reduce or prevent the diffusion of impurities into the circuit element. The buffer layer BFL may consist of a single layer, or may consist of multiple layers that are at least double layers. When the buffer layer BFL is provided in multiple layers, each layer may be made of the same material, or of a different material. Meanwhile, according to some embodiments, the buffer layer BFL may be omitted.

According to some embodiments, the first transistor T1 may include a semiconductor layer SCL, a gate electrode GE, a first transistor electrode ET1, and a second transistor electrode ET2. Meanwhile, although the first transistor T1 is shown to have the first transistor electrode ET1 and the second transistor electrode ET2 formed separately from the semiconductor layer SCL, the present disclosure is not limited thereto. For example, in other embodiments of the present disclosure, the first and/or second transistor electrodes ET1 and ET2 provided in at least one transistor may be integrated with the semiconductor layers SCL, respectively.

The semiconductor layer SCL may be located on the buffer layer BFL. For example, the semiconductor layer SCL may be located between the substrate SUB on which the buffer layer BFL is formed and the gate insulation layer GI. The semiconductor layer SCL may include a first region contacting the first transistor electrode ET1, a second region contacting the second transistor electrode ET2, and a channel region located between the first and second regions. According to some embodiments, one of the first and second regions may be a source region, and the other thereof may be a drain region.

According to some embodiments, the semiconductor layer SCL may be a semiconductor pattern made of polysilicon, amorphous silicon, oxide semiconductor, or the like. In addition, the channel region of the semiconductor layer SCL may be an intrinsic semiconductor as a semiconductor pattern in which impurity is not doped, and each of the first and second regions of the semiconductor layer SCL may be a semiconductor pattern in which a respective impurity (e.g., a predetermined impurity) is doped.

The gate electrode GE may be located on the semiconductor layer SCL with the gate insulation layer Gl interposed therebetween. For example, the gate electrode GE may be located between the gate insulation layer GI and the interlayer insulation layer ILD, while overlapping with at least one region of the semiconductor layer SCL.

The first and second transistor electrodes ET1 and ET2 may be located on the semiconductor layer SCL and the gate electrode GE with at least one interlayer insulation layer ILD interposed therebetween. For example, the first and second transistor electrodes ET1 and ET2 may be located between the interlayer insulation layer ILD and the passivation layer PSV. The first and second transistor electrodes ET1 and ET2 may be electrically connected to the semiconductor layer SCL. For example, each of the first and second transistor electrodes ET1 and ET2 may be connected to the first and second regions of the semiconductor layer SCL through contact holes passing through the gate insulation layer GI and interlayer insulation layer ILD, respectively.

On the other hand, according to some embodiments, any one of the first and second transistor electrodes ET1 and ET2 of at least one transistor (e.g., the first transistor T1) provided in the pixel driving circuit PXC may be electrically connected to the first electrode ELT1 of the light emitting element layer LDL located on the passivation layer PSV through the first contact hole CH1 passing through the passivation layer PSV.

According to some embodiments, at least one signal line and/or power line may be located on the same layer as one electrode of circuit elements constituting the pixel driving circuit PXC (see FIGS. 6A to 7B). For example, the second power line PL2 for supplying the second driving power supply VSS may be located on the same layer as the gate electrode GE of each of the first and second transistors T1 and T2, and may be electrically connected to the second electrode ELT2 of the light emitting element layer LDL located on passivation layer PSV through a bridge pattern BRP located on the same layer as the first and second transistor electrodes ET1 and ET2 and through at least one second contact hole CH2 passing through the passivation layer PSV. However, the structure and/or position of the second power line PL2 may be variously changed.

The light emitting element layer LDL may include the first, second, and third bank patterns PW1, PW2, and PW3, the first and second electrodes ELT1 and ELT2, a first insulation layer INS1, the light emitting element LD, a second insulation layer INS2, first to third contact electrodes CNE1, CNE2, and CNE3, and a third insulation layer INS3, which are sequentially located and/or formed on the pixel circuit layer PCL.

The first and second bank patterns PW1 and PW2 may be located on the pixel circuit layer PCL. The first and second bank patterns PW1 and PW2 may be located spaced apart from each other in the light emitting area EMA. The first and second bank patterns PW1 and PW2 may protrude in the third direction DR3 on the pixel circuit layer PCL. For example, a thickness TH1 of the first and second bank patterns PW1 and PW2 (see FIG. 10) may be within a range of about 1.5 µm to about 2.5 µm. According to some embodiments, the first and second bank patterns PW1 and PW2 may have substantially the same height as each other, but the present disclosure is not limited thereto.

According to some embodiments, the first bank pattern PW1 may be located between the pixel circuit layer PCL and the first electrode EL T1. The first bank pattern PW1 may be located to be adjacent to the first end EP1 of the light emitting element LD. For example, the first side surface SS1 of the first bank pattern PW1 may be located at a distance from, and adjacent to, the first end EP1 of the light emitting element LD, and may be located to face the first end EP1.

According to some embodiments, the second bank pattern PW2 may be located between the pixel circuit layer PCL and the second electrode ELT2. The second bank pattern PW2 may be located to be adjacent to the second end EP2 of the light emitting element LD. For example, one side surface of the second bank pattern PW2 may be located at a distance from, yet adjacent to, the second end EP2 of the light emitting element LD, and may be located to face the second end EP2.

According to some embodiments, the first and second bank patterns PW1 and PW2 may have various shapes. For example, the first and second bank patterns PW1 and PW2 each may have a cross-sectional shape of a trapezoid in which a width narrows as it goes upward (e.g., away from the substrate SUB), as shown in FIG. 9. In this case, each of the first and second bank patterns PW1 and PW2 may have an upper surface US that is substantially parallel to an upper surface of the substrate SUB, and a first side surface SS1 and a second side surface SS2, which are inclined with respect to the upper surface of the substrate SUB. However, the shape of the first and second bank patterns PW1 and PW2 is not limited thereto. For another example, the first and/or second bank patterns PW1 and PW2 may have a cross-sectional shape of a semicircle or a semi-ellipse in which a width narrows as the bank pattern goes upward. In this case, each of the first and second bank patterns PW1 and PW2 may have a curved surface at at least one side surface. When the first and second bank patterns PW1 and PW2 have a cross-section of a semi-circle or a semi-ellipse, a portion of the first and second bank patterns PW1 and PW2 may be defined as the upper surface of the first and second bank patterns PW1 and PW2, and an angle between a tangent line(s) (or tangent plane) of the portion and the upper surface of the substrate SUB may be about 30 degrees or less, or about 10 degrees or less. That is, the shape of the first and second bank patterns PW1 and PW2 in the present disclosure is not particularly limited, and may be variously changed. In addition, according to some embodiments, at least one of the first and second bank patterns PW1 and PW2 may be omitted, or the position thereof may be changed.

The first and second bank patterns PW1 and PW2 may include an insulation material including an inorganic material and/or an organic material. For example, the first and second bank patterns PW1 and PW2 may include at least one inorganic layer including one or more various inorganic insulation materials, in addition to SiNₓ or SiOₓ. Alternatively, the first and second bank patterns PW1 and PW2 may include at least one organic layer including one or more various organic insulation materials and/or a photoresist layer, or may consist of an insulator of a single-layer or multi-layer structure including a combination of organic/inorganic materials. That is, the constituent materials of the first and second bank patterns PW1 and PW2 may be variously changed.

In some embodiments, the first and second bank patterns PW1 and PW2 may function as a reflective member. For example, the first and second bank patterns PW1 and PW2 may function as a reflective member that guides light that is emitted from each light emitting element LD in a desired direction to improve light efficiency of the pixel PXL together with the first and second electrodes ELT1 and ELT2 provided thereon.

The first and second electrodes ELT1 and ELT2 are located on the first and second bank patterns PW1 and PW2, respectively. The first and second electrodes ELT1 and ELT2 may be spaced apart from each other in the light emitting area EMA.

According to some embodiments, the first and second electrodes ELT1 and ELT2 located on the first and second bank patterns PW1 and PW2, respectively, may have a shape corresponding to the first and second bank patterns PW1 and PW2, respectively. For example, the first and second electrodes ELT1 and ELT2 may protrude in the third direction DR3 while having an inclined surface or a curved surface corresponding to a shape of the first and second bank patterns PW1 and PW2, respectively.

Each of the first and second electrodes ELT1 and ELT2 may include at least one conductive material. For example, each of the first and second electrodes ELT1 and ELT2 may include at least one material of metals such as Ag, Mg, Al, Pt, Pd, Au, Ni, Nd, Ir, Cr, Ti, and alloys thereof, a conductive oxide such as ITO, IZO, ZnO, and ITZO, and a conductive polymer such as PEDOT, but is not limited thereto.

In addition, each of the first and second electrodes ELT1 and ELT2 may consist of a single layer or multi-layer. For example, each of the first and second electrodes ELT1 and ELT2 may include at least one reflective electrode layer. In addition, each of the first and second electrodes ELT1 and ELT2 may selectively further include at least one among a transparent electrode layer(s) located on and/or under the reflective electrode layer, and a conductive capping layer(s) covering the upper portion of the reflective electrode layer(s) and/or transparent electrode layer(s).

According to some embodiments, the reflective electrode layer of each of the first and second electrodes ELT1 and ELT2 may be made of a conductive material having uniform reflectance. For example, the reflective electrode layer may include at least one of metals such as Ag, Mg, Al, Pt, Pd, Au, Ni, Nd, Ir, Cr, and alloys thereof, but is not limited thereto. That is, the reflective electrode layer may be made of various reflective conductive materials. When each of the first and second electrodes ELT1 and ELT2 includes a reflective electrode layer, the light emitted from both ends of the light emitting element LD (e.g., from the first and second ends EP1 and EP2) may be further advanced in the direction (e.g., front direction) in which an image is displayed. For example, when the first and second electrodes ELT1 and ELT2 are located to face the first and second ends EP1 and EP2 of the light emitting element LD while having an inclined or curved surface corresponding to the shape of the first and second bank patterns PW1 and PW2, the light emitted from the first and second ends EP1 and EP2 of the light emitting element LD may be reflected by the first and second electrodes ELT1 and ELT2, and may be further advanced to, or directed toward, the third direction DR3. Accordingly, the efficiency of light emitted from the light emitting element LD may be improved.

In addition, the transparent electrode layer of each of the first and second electrodes ELT1 and ELT2 may be made of various transparent electrode materials. For example, the transparent electrode layer may include ITO, IZO or ITZO, but is not limited thereto. In some embodiments, each of the first and second electrodes ELT1 and ELT2 may consist of a triple layer having a stacked structure of ITO/Ag/ITO. As described above, when the first and second electrodes ELT1 and ELT2 are composed of multiple layers that are at least double layers, a voltage drop due to a signal delay (e.g., due to RC delay) may be minimized. Accordingly, it is possible to effectively transfer the desired voltage to the light emitting element LD.

Additionally, because each of the first and second electrodes ELT1 and ELT2 includes a conductive capping layer that covers the reflective electrode layer and/or transparent electrode layer, it is possible to reduce or prevent damage to the reflective electrode layer of the first and second electrodes ELT1 and ELT2 due to defects occurring in the manufacturing process of the pixel. However, the conductive capping layer may be selectively included in the first and second electrodes ELT1 and ELT2, and may be omitted according to some embodiments. In addition, the conductive capping layer may be considered as a constituent element of each of the first and second electrodes ELT1 and ELT2, or as a separate constituent element located on the first and second electrodes ELT1 and ELT2.

The first insulation layer INS1 may be located on one or more respective regions of the first and second electrodes ELT1 and ELT2. For example, the first insulation layer INS1 may be formed to cover one or more respective regions of the first and second electrodes ELT1 and ELT2, and may include an opening that exposes another region of the first and second electrodes ELT1 and ELT2.

In some embodiments, the first insulation layer INS1 may be initially formed to entirely cover the first and second electrodes ELT1 and ELT2. After the light emitting element(s) LD are supplied and aligned on the first insulation layer INS1, the first insulation layer INS1 may be partially opened, or removed, to expose a portion of a side surface and an upper surface of each of the first and second electrodes ELT1 and ELT2, as shown in FIG. 9. Alternatively, the first insulation layer INS1 may be patterned in the form of individual patterns that are locally located under the light emitting elements LD after a supply and an alignment of the light emitting elements LD are completed.

That is, the first insulation layer INS1 may be interposed between the first and second electrodes ELT1 and ELT2 and the light emitting elements LD, and may expose at least one region of each of the first and second electrodes ELT1 and ELT2. The first insulation layer INS1 may be formed to cover the first and second electrodes ELT1 and ELT2 after the first and second electrodes ELT1 and ELT2 are formed, thereby reducing or preventing damage to the first and second electrodes ELT1 and ELT2, and/or reducing or preventing metals from being deposited in a subsequent process(es). In addition, the first insulation layer INS1 may stably support each light emitting element LD.

The light emitting element LD may be supplied and aligned in the light emitting area EMA (see FIG. 8) in which the first insulation layer INS1 is formed. For example, the light emitting element LD may be supplied to the light emitting area EMA through the inkjet method, and the like, and the light emitting element LD may be arranged between the first and second electrodes ELT1 and ELT2 by a voltage (e.g., predetermined alignment voltage/alignment signal) applied to the first and second electrodes ELT1 and ELT2.

The second insulation layer INS2 (or insulation pattern) is located on the light emitting element LD (e.g., the light emitting element LD arranged between first and second electrodes ELT1 and ELT2), and exposes the first and second ends EP1 and EP2 of the light emitting elements LD. For example, the second insulation layer INS2 might not cover the first and second ends EP1 and EP2 of the light emitting element LD, and may be partially located only on one region of the light emitting element LD. The second insulation layer INS2 may be formed in an independent pattern, but is not limited thereto. Also, as shown in FIG. 9, when a separation space existed between the first insulation layer INS1 and the light emitting elements LD before the second insulation layer INS2 is formed, the separation space may be filled by the second insulation layer INS2. Accordingly, the light emitting elements LD may be more stably supported.

As shown in FIG. 10, the second insulation layer INS2 may include a first side surface SS1 facing the first electrode ELT1, a second side surface SS2 facing the second electrode ELT2, and an upper surface US substantially parallel to the upper surface of the substrate SUB between the first and second side surfaces SS1 and SS2. As shown in FIG. 9, the second insulation layer INS2 may have a cross-section of a trapezoid, but a cross-sectional shape of the second insulation layer INS2 is not limited thereto.

According to the invention, a thickness TH2 of the second insulation layer INS2 is within a range of about 50% to about 150% of a thickness TH1 of the first bank pattern PW1 (and/or second bank pattern PW2). For example, when the thickness TH1 of the first bank pattern PW1 is about 2 µm, the thickness TH2 of the second insulation layer INS2 may be within a range of about 1 µm to about 3 µm, within the range of about 1.5 µm to about 2.5 µm, or about 2 µm.

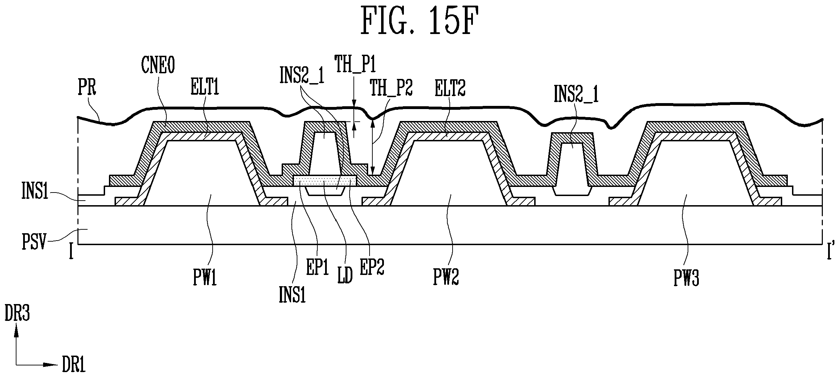

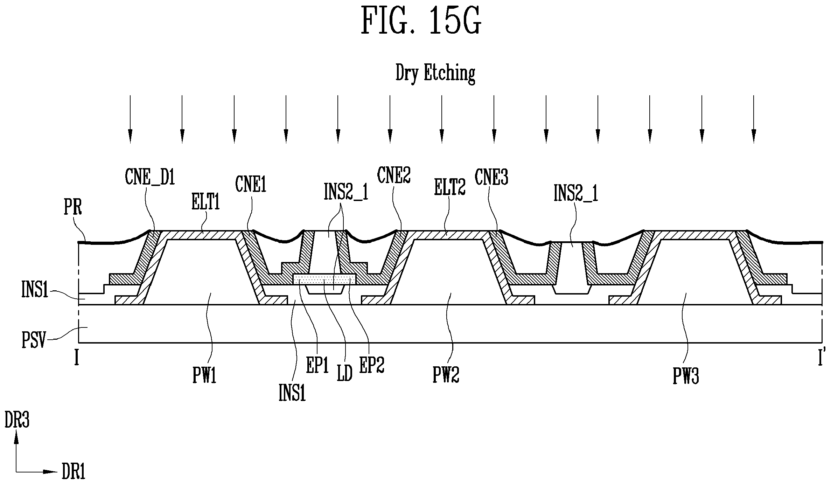

Referring to FIG. 10, and as described later with reference to FIGS. 15F and 15G, to form the first and second contact electrodes CNE1 and CNE2 through one etching process without a separate mask, a depth DEP1 of a trough formed between the first bank pattern PW1 and the second insulation layer INS2 (e.g., a depth of a trough with respect to the upper surface US of the second insulation layer INS2, or a depth DEP2 of a trough formed between the second bank pattern PW2 and the second insulation layer INS2) may be greater than about a half of the thickness TH1 of the first bank pattern PW1 (and/or, of the second bank pattern PW2), for example, may be greater than about 1 µm. Therefore, the thickness TH2 of the second insulation layer INS2 is, in accordance with the invention, greater than about 50% of the thickness TH1 of the first bank pattern PW1.

As the thickness TH2 of the second insulation layer INS2 is increased, the first and second contact electrodes CNE1 and CNE2 may be more easily formed, although a thickness of the light emitting element layer LDL may be increased, and defects may occur in the second insulation layer INS2. Therefore, the thickness TH2 of the second insulation layer INS2 is, in accordance with the invention, less than about 150% of the thickness TH1 of the first bank pattern PW1.

According to some embodiments, with respect to the upper surface of the substrate SUB, a maximum height of the upper surface US of the second insulation layer INS2 may be greater than or about equal to a height H1 of the upper surface US of the first bank pattern PW1 and/or of the second bank pattern PW2.

The thickness TH2 of the second insulation layer INS2 (or of a portion of the second insulation layer INS2) overlapping the light emitting element LD may be equal to the thickness TH3 of the second insulation layer INS2 not overlapping (or non-overlapping) with the light emitting element LD. However, because a step (or height difference), with respect to the substrate SUB, is formed due to the presence of the light emitting element LD, the height H2 of the upper surface US of the second insulation layer INS2 overlapping with the light emitting element LD may be greater than the height H3 of the upper surface of the second insulation layer INS2 not overlapping with the light emitting element LD.

With respect to the substrate SUB, the height H2 of the upper surface US of the second insulation layer INS2 overlapping the light emitting element LD may be greater than or about equal to the height H1 of the upper surface US of the first bank pattern PW1 and/or of the upper surface US of the second bank pattern PW2, and the height H3 of the upper surface of the second insulation layer INS2 not overlapping with the light emitting element LD may be less than the height H1 of the upper surface US of the first bank pattern PW1 and/or the second bank pattern PW2.

When considering the thickness of the first electrode ELT1 (e.g., a thickness of about 0.2µm), the thickness of the first insulation layer INS1 (e.g., a thickness of about 0.3µm), and the thickness of the light emitting element LD, with respect to the substrate SUB, the height H2 of the upper surface US of the second insulation layer INS2 overlapping with the light emitting element LD may be equal to the height H1 of the upper surface of the first bank pattern PW1 and/or the second bank pattern PW2.

The first and second contact electrodes CNE1 and CNE2 may be located on the first and second electrodes ELT1 and ELT2 and on the first and second ends EP1 and EP2 of the light emitting elements LD. In some embodiments, the first and second contact electrodes CNE1 and CNE2, as shown in FIG. 9, may be located on the same layer. In this case, the first and second contact electrodes CNE1 and CNE2 may be formed using the same conductive material in the same process.

The first and second contact electrodes CNE1 and CNE2 may electrically connect the first and second ends EP1 and EP2 of the light emitting element LD to the first and second electrodes ELT1 and ELT2, respectively.

The first contact electrode CNE1 may be located on the first electrode ELT1 to contact the first electrode ELT1. For example, the first contact electrode CNE1 may be located to contact the first electrode ELT1 on one region of the first electrode ELT1 that is not covered by the first insulation layer INS1 (e.g., to contact the first side surface of the first electrode ELT1, or to contact the first side surface SS1 of the first bank pattern PW1). In addition, the first contact electrode CNE1 may be located on the first end EP1 to contact the first end EP1 of the light emitting element LD adjacent to the first electrode ELT1. That is, the first contact electrode CNE1 may be located to cover the first end EP1 of the light emitting element LD and at least one region of the first electrode ELT1 corresponding thereto. Therefore, the first end EP1 of the light emitting elements LD may be electrically connected to the first electrode ELT1.

According to some embodiments, the first contact electrode CNE1 may be located on the first side surface SS1 of the second insulation layer INS2, and might not overlap with the upper surface US of the second insulation layer INS2. The first contact electrode CNE1 may entirely cover the first side surface SS1 of the second insulation layer INS2, and the height of one end of the first contact electrode CNE1 (e.g., an end of the first contact electrode CNE1 contacting the second insulation layer INS2) may be almost equal to a height H2 of the upper surface US of the second insulation layer INS2. In addition, the first contact electrode CNE1 may be located on one side surface of the first electrode ELT1, and might not overlap the upper surface of the first electrode ELT1. The first contact electrode CNE1 may entirely cover one side surface of the first electrode ELT1, and the height of the other end of the first contact electrode CNE1 (e.g., an end of the first contact electrode CNE1 contacting the first electrode ELT1) may be almost equal to the height of the upper surface of the first electrode ELT1. The first contact electrode CNE1 may be located on the first side surface SS1 of the first bank pattern PW1, and might not overlap the upper surface US of the first bank pattern PW1. In other words, in a plane view (e.g., when viewing in a plane), the first contact electrode CNE1 may be spaced apart from the upper surface US of the first bank pattern PW1.

Similarly, the second contact electrode CNE2 may be located on the second electrode ELT2 to contact the second electrode ELT2. For example, the second contact electrode CNE2 may be located to contact the second electrode ELT2 on one region (e.g., on one side surface of the second electrode ELT2, or on one side surface of the second bank pattern PW2) that is not covered by the first insulation layer INS1. In addition, the second contact electrode CNE2 may be located on the second end EP2 of the light emitting element LD to contact the second end EP2 of the light emitting element LD at a region adjacent to the second electrode ELT2. That is, the second contact electrode CNE2 may be located to cover both the second end EP2 of the light emitting element LD and at least one region of the second electrode ELT2 corresponding thereto. Therefore, the second end EP2 of the light emitting elements LD may be electrically connected to the second electrode ELT2.

According to some embodiments, the second contact electrode CNE2 may be located on the second side surface SS2 of the second insulation layer INS2, and might not overlap with the upper surface US of the second insulation layer INS2. In addition, the second contact electrode CNE2 may be located on the side surface of the second electrode ELT2, and might not overlap with the upper surface of the second electrode ELT2. The second contact electrode CNE2 may be located on one side surface of the second bank pattern PW2, and might not overlap with the upper surface of the second bank pattern PW2.

The third contact electrode CNE3 (or fifth electrode) may be located on the second electrode ELT2 to contact the second electrode ELT2, and may be spaced apart from the second contact electrode CNE2. For example, the third contact contact electrode CNE3 may be located to contact the second electrode ELT2 on one region (e.g., the other side surface of the second electrode ELT2, or the other side surface of the second bank pattern PW2) that is not covered by the first insulation layer INS1. With respect to the second bank pattern PW2, the third contact electrode CNE3 may be symmetrical to the second contact electrode CNE2, and may be substantially equal to or similar to the second contact electrode CNE2. Accordingly, duplicate descriptions thereof will be omitted.

According to some embodiments, and referring to FIG. 9, the light emitting element layer LDL may further include a dummy contact electrode CNE_D1 (or dummy electrode). The dummy contact electrode CNE_D1 may be located on the first electrode ELT1 to be in contact with the first electrode ELT1, and may be spaced apart from the first contact electrode CNE1. For example, the dummy contact electrode CNE1_D1 may be located to be in contact with the first electrode ELT1 on one region (e.g., second side surface of the first electrode ELT1, or the second side surface SS2 of the first bank pattern PW1) that is not covered by the first insulation layer INS1. The dummy contact electrode CNE_D1 might not contact any light emitting element.

Third insulation layer INS3 may be entirely formed and/or located on one surface of the substrate SUB to cover the first, second, and third bank patterns PW1, PW2, and PW3, the first and second electrodes ELT1 and ELT2, the light emitting elements LD, the first to third contact electrodes CNE1, CNE2, and CNE3, and the dummy contact electrode CNE_D1. The third insulation layer INS3 may include a thin film encapsulation layer including at least one inorganic layer and/or organic layer, but is not limited thereto. In addition, according to some embodiments, at least one overcoat layer may be further located on the third insulation layer INS3.

According to some embodiments, each of the first to third insulation layers INS1, INS2, and INS3 may be composed of a single layer or of multiple layers, and may include at least one inorganic insulation material and/or organic insulation material. For example, each of the first to third insulation layers INS1, INS2, and INS3 may include various types of organic/inorganic insulation materials currently known, including SiNₓ, and the constituent material of each of the first to third insulation layers INS1, INS2, and INS3 is not particularly limited. In addition, the first to third insulation layers INS1, INS2, and INS3 may include different insulation materials, or at least some of first to third insulation layers INS1, INS2, and INS3 may include the same insulation material.

As described with reference to FIGS. 9 and 10, the thickness TH2 of the second insulation layer INS2 is, in accordance with the invention, within a range of about 50% to about 150% of the thickness TH1 of the first bank pattern PW1 and/or the second bank pattern PW2, and the height H2 (or maximum height) of the upper surface US of the second insulation layer INS2 may be greater than or equal to the height H1 of the upper surface US of the first bank pattern PW1 and/or the second bank pattern PW2 with respect to the substrate SUB. Therefore, the first and second contact electrodes CNE1 and CNE2 may be substantially simultaneously, or concurrently, formed through one etching process without a separate mask (and also without a separate exposure process or photolithography process). The first and second contact electrodes CNE1 and CNE2 formed through one etching process may be located on the side surfaces of the first and second electrodes ELT1 and ELT2 (or of the first and second bank patterns PW1 and PW2), respectively, and might not overlap with the upper surface of the first and second electrodes ELT1 and ELT2 (or of first and second bank patterns PW1 and PW2).

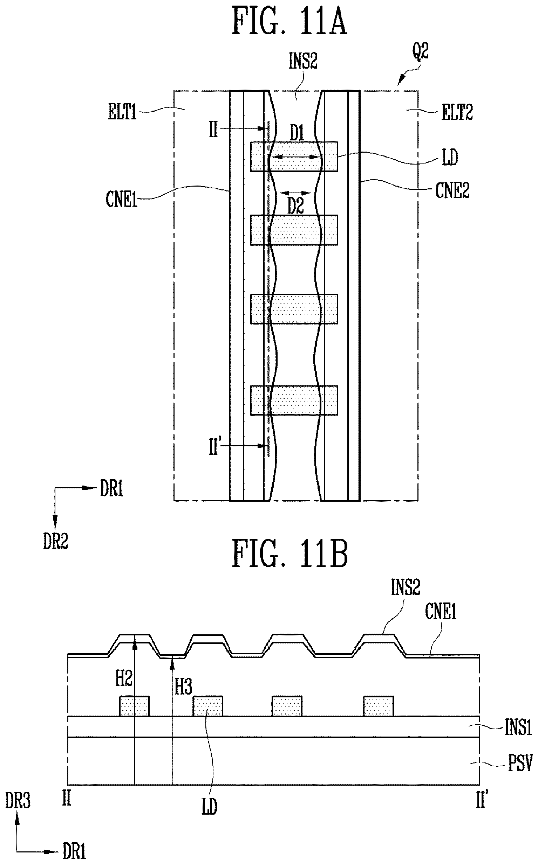

FIG. 11A is a top plan view enlarging the Q1 area of FIG. 8. FIG. 11B is a cross-sectional view showing an example of a pixel taken along the line II-II' of FIG. 11A. In FIGS. 11A and 11B, the pixel is briefly shown, centering on the light emitting element layer LDL (see FIG. 9).

First, referring to FIGS. 8-11A, in a plane view, a distance in the first direction DR1 between the first contact electrode CNE1 and the second contact electrode CNE2 may be not constant, and may change with respect to the second direction DR2 (or with respect to the extending direction of the first bank pattern PW1).

As shown in FIG. 11A, a first distance D1 between the first contact electrode CNE1 and the second contact electrode CNE2 at the portion overlapping with the light emitting element LD may be greater than a second distance D2 between the first contact electrode CNE1 and the second contact electrode CNE2 at the portion not overlapping with the light emitting element LD.

As shown in FIG. 11B, the height H2 of the second insulation layer INS2 overlapping with the light emitting element LD may be greater than the height H3 of the second insulation layer INS2 not overlapping with the light emitting element LD. That is, a step may be formed on the upper surface of the second insulation layer INS2 by the light emitting element LD. Accordingly, a thickness of a photoresist (e.g., a photoresist formed on the second insulation layer INS2 to form the first contact electrode CNE1 and the second contact electrode CNE2), which will be described below with reference to FIG. 15F, may change in the first direction DR1. For example, the photoresist may fill in a recess portion (or a valley) of the second insulation layer INS2, and the thickness of the photoresist at the portion not overlapping with the light emitting element LD may be greater than the thickness of the photoresist at the portion overlapping with the light emitting element LD. Therefore, the first contact electrode CNE1 and the second contact electrode CNE2 may be relatively more etched in a portion where the thickness of the photoresist is relatively small, and the first contact electrode CNE1 and the second contact electrode CNE2 may be relatively less etched in a portion where the thickness of the photoresist is relatively large. Therefore, the first distance D1 between the first contact electrode CNE1 and the second contact electrode CNE2 in the portion overlapping with the light emitting element LD may be greater than the second distance D2 between the first contact electrode CNE1 and the second contact electrode CNE2 in the portion not overlapping with the light emitting element LD.

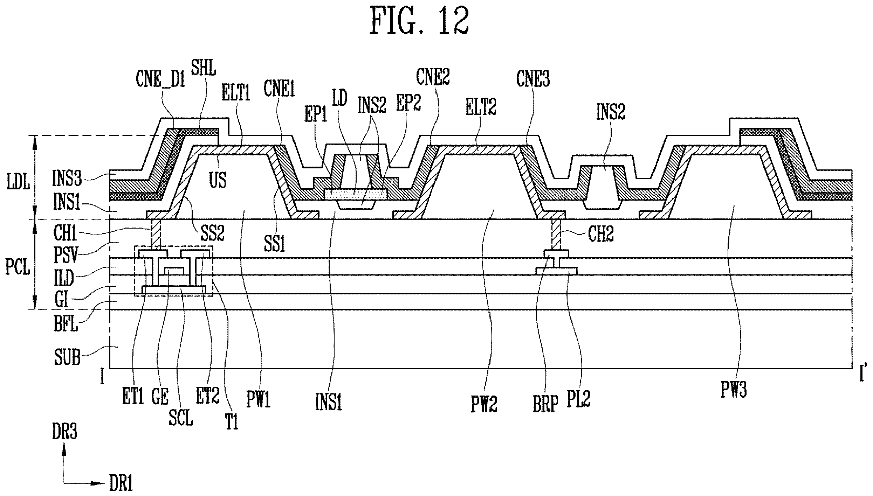

FIGS. 12 to 14 are cross-sectional views showing another example of a pixel taken along the line I-I' of FIG. 8. In FIGS. 12 to 14, cross-sectional views corresponding to FIG. 9 are shown. In the following example, the same configuration(s) as that included in the pixel of FIG. 9 will be omitted or simplified, and the differences therebetween will be mainly described. Parts not specifically described in other embodiments follow the embodiment described above.

First, referring to FIGS. 8, 9, and 12, the light emitting element layer LDL may further include a shield layer SHL.

The first insulation layer INS1 may also be located on a portion of the second side surface SS2 and the upper surface US of the first bank pattern PW1 (or of the first electrode ELT1).

The shield layer SHL may be located on the first insulation layer INS1, and may be located on a portion of the second side surface SS2 and the upper surface US of the first bank pattern PW1 (or of the first electrode ELT1). For example, the shield layer SHL may be located on an outer area of the light emitting area EMA in a form surrounding the light emitting area EMA (see FIG. 8) in a plane view, and may be overlapped with the bank BNK (see FIG. 8). In addition, the shield layer SHL may be formed to cover upper portions of the first and second electrodes ELT1 and ELT2 in an area adjacent to the outer area of the light emitting area EMA.

According to some embodiments, the shield layer SHL may be a conductive pattern including at least one conductive material. For example, the shield layer SHL may be composed of at least one transparent conductive layer including a transparent conductive material, such as IZO, but is not limited thereto. That is, the shield layer SHL may be composed of various conductive materials, and the constituent material thereof is not particularly limited.

The shield layer SHL may allow the light emitting element LD to be properly aligned inside the light emitting area EMA. For example, the shield layer SHL may cancel the electric field otherwise generated between adjacent pixels. Accordingly, it may reduce or prevent the light emitting element LD from aligning on the outer area of the pixels, and the light emitting element LD may be properly aligned inside the light emitting area EMA of each pixel PXL.

The shield layer SHL may be in an electrically isolated floating state, but is not limited thereto. For example, in other embodiments, the shield layer SHL may be connected to a voltage source (e.g., a predetermined reference voltage source).

The dummy contact electrode CNE_D1 may be formed on one side surface (or inclined surface) of the shield layer SHL, and the height of one end of the dummy contact electrode CNE_D1 (e.g., an end of the dummy contact electrode CNE_D1 contacting the shield layer SHL) may be almost equal to the height of the upper surface of the shield layer SHL.

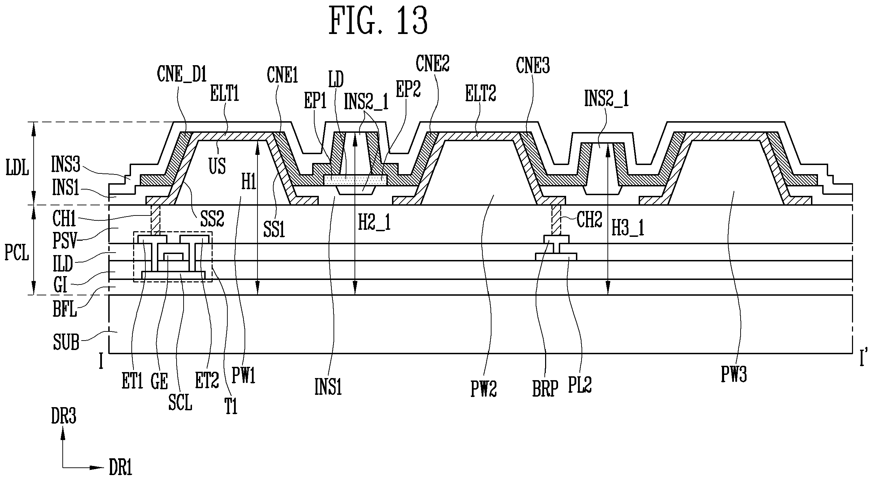

Referring to FIGS. 9 and 13, with respect to the substrate SUB, the height H2_1 (e.g., a maximum height) of the upper surface of the second insulation layer INS2_1 (or insulation pattern) may be greater than the height H1 of the first bank pattern PW1 and/or of second bank pattern PW2.

For example, the height H2_1 of the second insulation layer INS2_1 overlapping with the light emitting element LD may be substantially equal to the height of the upper surface of the first electrode ELT1. For example, the height H3_1 of the second insulation layer INS2_1 not overlapping with the light emitting element LD may be substantially equal to the height H1 of the upper surface of the first bank pattern PW1.

In this case, the first contact electrode CNE1 and the second contact electrode CNE2 may be suitably formed to be separated from each other on the upper surface of the second insulation layer INS2_1. In addition, excessive etching of a portion of the first contact electrode CNE1 contacting the first electrode ELT1 may be reduced or prevented, the first contact electrode CNE1 may be more stably connected to the first electrode ELT1, and the contact resistance between the first contact electrode CNE1 and the first electrode ELT1 may be reduced.

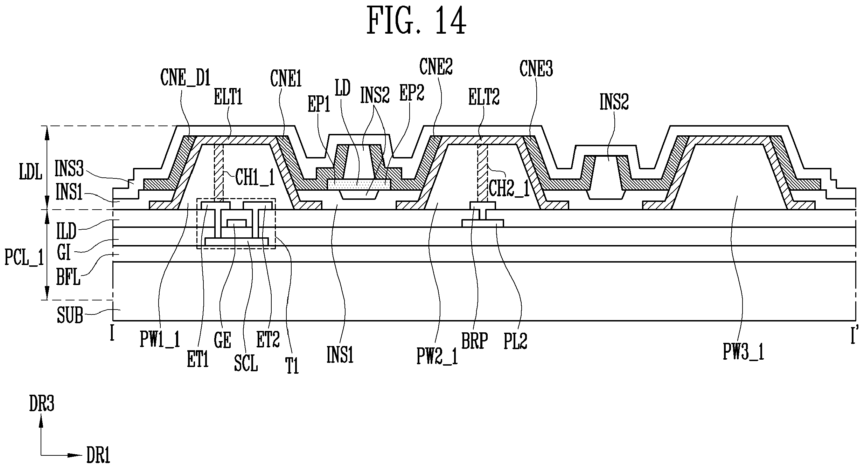

Referring to FIGS. 9 and 14, the pixel circuit layer PCL_1 might omit a passivation layer PSV.

The first and second bank patterns PW1_1 and PW2_1 (and also the third bank pattern PW3_1) may be formed directly on the interlayer insulation layer ILD.

For example, the first bank pattern PW1_1 may cover the first transistor electrode ET1 and the second transistor electrode ET2 of the first transistor T1. One of the first and second transistor electrodes ET1 and ET2 may be connected to, or electrically connected to, the first electrode ELT1 through a first contact hole CH1_1 passing through the first bank pattern PW1_1. For example, the second bank pattern PW2_1 may cover a bridge pattern BRP. The second power line PL2 may be connected to, or electrically connected to, the second electrode ELT2 through the bridge pattern BRP and a second contact hole CH2_1 passing through second bank pattern PW2_1. That is, circuit elements of the pixel driving circuit PXC described with reference to FIGS. 6A to 7B may overlap with the first and second bank patterns PW1_1 and PW2_1 (and may also overlap the third bank pattern PW3_1).

A layer including the first and second bank patterns PW1_1 and PW2_1 may planarize the upper surface of the pixel circuit layer PCL_1, and may also provide a space in which the light emitting element LD can be located. As the passivation layer PSV is omitted, the manufacturing process of the display device may be simplified.

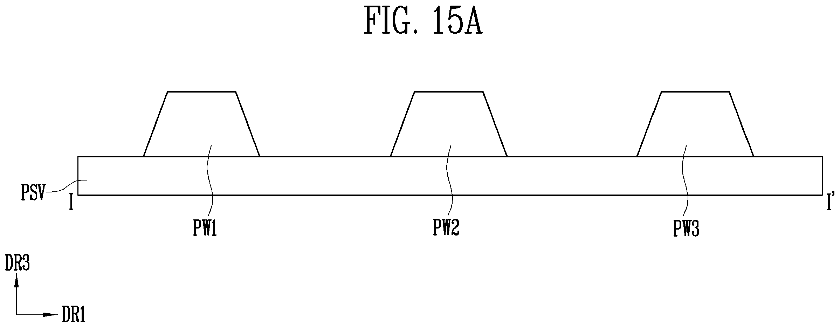

FIGS. 15A to 15H are cross-sectional views sequentially showing a manufacturing method of a display device according to some embodiments of the present disclosure. In FIGS. 15A to 15H, the structure thereof is schematically shown focusing some constituent elements of the pixel circuit layer PCL described with reference to FIG. 9, and repeated detailed description thereof will be omitted.

First, Referring to FIGS. 9, 13 and 15A, the pixel circuit layer PCL (e.g., the pixel circuit layer PCL including the passivation layer PSV) formed on the substrate SUB may be prepared.

The first and second bank patterns PW1 and PW2 (and the third bank pattern PW3) may be formed on the pixel circuit layer PCL. For example, as described with reference to FIG. 9, the first and second bank patterns PW1 and PW2 may be formed on the passivation layer PSV of the pixel circuit layer PCL. For another example, as described with reference FIG. 14, the first and second bank patterns PW1 and PW2 may be located on the interlayer insulation layer ILD. The first and second bank patterns PW1 and PW2 may be located to be spaced apart from each other in the first direction DR1.

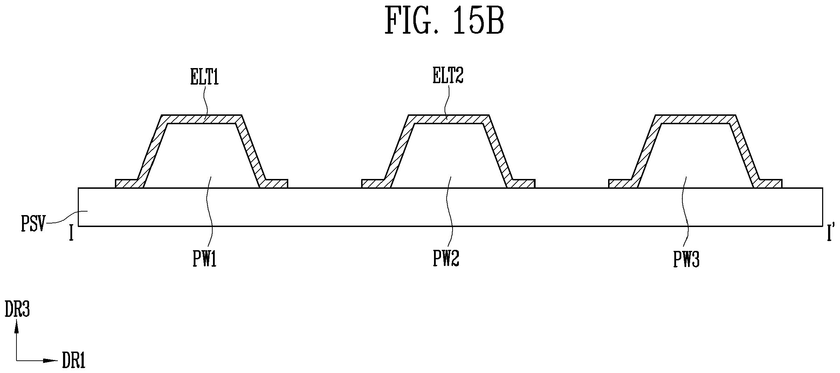

Referring to FIG. 15B, the first and second electrodes ELT1 and ELT2 are formed on the first and second bank patterns PW1 and PW2, respectively. The first and second electrodes ELT1 and ELT2 are located to be spaced apart from each other. The first electrode ELT1 may overlap with the first bank pattern PW1, and may cover the first bank pattern PW1. The second electrode ELT2 may overlap with the second bank pattern PW2, and may cover the second bank pattern PW2.

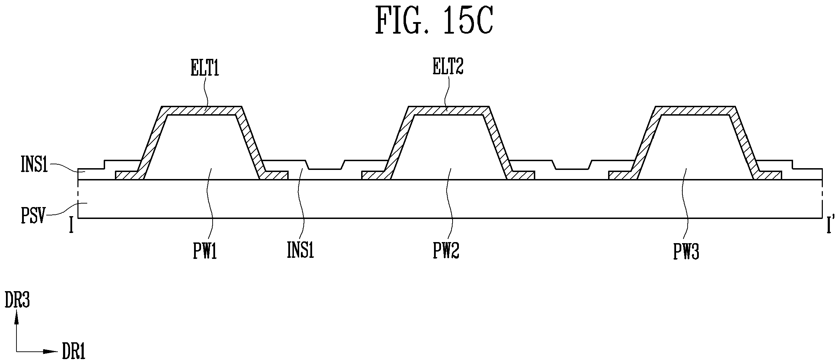

Referring to FIG. 15C, the first insulation layer INS1 may be formed on first and second electrodes ELT1 and ELT2 and the passivation layer PSV. The first insulation layer INS1 may be formed or patterned on the passivation layer PSV to cover one region of the first and second electrodes ELT1 and ELT2, and to cover the passivation layer PSV exposed by the first and second electrodes ELT1 and ELT2.

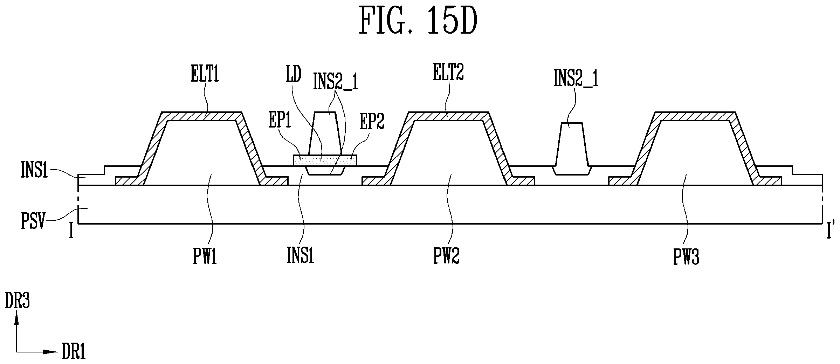

Referring to FIG. 15D, the light emitting element LD is located between the first bank pattern PW1 and the second bank pattern PW2, and the second insulation layer INS2_1 is located on the light emitting element LD.

The light emitting element LD may be supplied or located to the light emitting area EMA described with reference to FIG. 8. The light emitting element LD may be dispersed in a solution (or solvent), and may be supplied to the light emitting area EMA through an inkjet method or the like. However, the supply method of the light emitting element LD is not limited thereto, and the light emitting element LD may be supplied to the light emitting area EMA through various methods in addition thereto.

Next, an alignment voltage may be applied to the first and second electrodes ELT1 and ELT2, and an electric field may be formed in the light emitting area EMA. Accordingly, the light emitting element LD may be self-aligned between the first and second electrodes ELT1 and ELT2.

A ground voltage GND may be applied to the first electrode ELT1, and an alternating current voltage AC may be applied to the second electrode ELT2. Alternatively, the alternating current voltage AC may be applied to the first electrode ELT1, and the ground voltage GND may be applied to the second electrode ELT2.

The supply and alignment steps of the light emitting element LD may be performed sequentially or substantially simultaneously. For example, the light emitting element LD may be aligned by supplying the alignment voltage to the first electrode ELT1 and the second electrode ELT2 while supplying the light emitting element LD to the light emitting area EMA. For another example, the light emitting element LD may be aligned by supplying the alignment voltage to the first electrode ELT1 and to the second electrode ELT2 after supplying the light emitting element LD to the light emitting area EMA. That is, the order and/or the method of the supply and alignment of the light emitting element LD are not particularly limited.

The light emitting elements LD may be stably arranged between the first electrode ELT1 and the second electrode ELT2 by volatilizing the solution or removing the solution by using another method after the light emitting element LD is aligned.

The second insulation layer INS2_1 is formed on the light emitting element LD, that is, on the light emitting element LD aligned between the first and second electrodes ELT1 and ELT2. The second insulation layer INS2_1 may fill in the separation space between the first insulation layer INS1 and the light emitting elements LD.

The second insulation layer INS2_1 may be partially patterned to expose , in accordance with the invention, the first and second ends EP1 and EP2 of the light emitting element LD. In addition, when forming the pattern of the second insulation layer INS2_1, the first insulation layer INS1 may be partially removed. At this time, the first and second electrodes ELT1 and ELT2 may be exposed.

As described with reference to FIG. 10, the thickness TH2 of the second insulation layer INS2_1 may be within a range of about 50% to about 150% of the thickness TH1 of the first bank pattern PW1 and/or of the second bank pattern PW2. In addition, as described with reference to FIG. 9, with respect to the substrate, the height (or the maximum height) of the upper surface of the second insulation layer INS2_1 may be greater than or about equal to the height H1 of the upper surface of the first bank pattern PW1. For example, with respect to the substrate, the height H2 of the upper surface of the second insulation layer INS2_1 overlapping with the light emitting element LD may be greater than the height H1 of the upper surface of the first bank pattern PW1, and may be about equal to the height of the upper surface of the first electrode ELT1. For example, with respect to the substrate, the height H3 of the upper surface of the second insulation layer INS2_1 that does not overlap with the light emitting element LD may be about equal to the height H1 of the upper surface of the first bank pattern PW1.

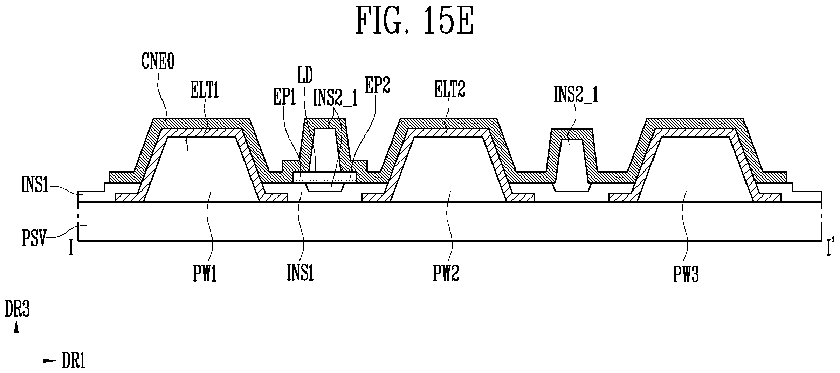

Referring to FIG. 15E, the contact electrode layer CNE0 (or parent electrode layer) is entirely formed on the passivation layer PSV to cover the second insulation layer INS2_1, the first insulation layer INS1, and the first and second electrodes ELT1 and ELT2.

Referring to FIG. 15F, a photoresist PR (or photoresist layer) is formed on the contact electrode layer CNE0. The photoresist PR may include a positive type of photoresist composition, but is not limited thereto.

The photoresist PR may be filled between the first bank pattern PW1 and the second insulation layer INS2_1, and between the second bank pattern PW2 and second insulation layer INS2_1. Therefore, the thickness TH_P2 of the photoresist PR that does not overlap with the second insulation layer INS2_1 (and does not overlap the first and second bank patterns PW1 and PW2) may be greater than the thickness TH_P1 of the photoresist PR that overlaps with the second insulation layer INS2_1 (or that overlaps the first and second bank patterns PW1 and PW2). In the etching process described later, the thickness of the second insulation layer INS2_1 should be large enough so that the photoresist PR not overlapping with the second insulation layer INS2_1 (and not overlapping with the first and second bank patterns PW1 and PW2) is not unintentionally removed (e.g., only the photoresist PR overlapping with the second insulation layer INS2_1 and/or the first and second bank patterns PW1 and PW2 may be removed).

Referring to FIG. 15G, through the etching process (or etching technology), a portion of the photoresist PR and a portion of the contact electrode layer CNE0, overlapping with the second insulation layer INS2_1 (and with the first and second bank patterns PW1 and PW2) is removed. For example, through a dry etching process using gas plasma or activated gas, a structure shown in FIG. 15F may be entirely etched by, roughly, a given thickness (e.g., by a thickness in the third direction DR3 from the upper surface of the photoresist PR to the upper surface of the second insulation layer INS2_1). Therefore, a portion of the contact electrode layer CNE0 overlapping with the second insulation layer INS2_1 is removed, so the first contact electrode CNE1 and the second contact electrode CNE2 are formed. Even if an etch-rate of the photoresist PR and the contact electrode layer CNE0 is different, the photoresist PR not overlapping with first and second bank patterns PW1 and PW2 (e.g., a relatively thick portion of the photoresist PR) may remain in the etching process, and may protect the first and second contact electrodes CNE1 and CNE2 thereunder.

In addition, a portion of the contact electrode layer CNE0 overlapping with the first and second bank patterns PW1 and PW2 may be removed, thereby forming the dummy contact electrode CNE_D1 and the third contact electrode CNE3.

For reference, the first contact electrode CNE1 and the second contact electrode CNE2 may be concurrently or substantially simultaneously formed using exposure technology. For example, by removing a portion of the contact electrode layer CNE0 overlapping with the second insulation layer INS2_1 using an exposer, the first contact electrode CNE1 and the second contact electrode CNE2 may be substantially simultaneously or concurrently formed. However, because the second insulation layer INS2_1 may suitably expose both ends of the light emitting element LD, a width (e.g., a width in the first direction DR1) of the upper surface of the second insulation layer INS2_1 may be less than a length of the light emitting element LD, and it might not be easy to separate the contact electrode layer CNE0 from the upper surface of the second insulation layer INS2_1 according to the specification of (or the resolution of, or qualities of) the exposer. Accordingly, according to a manufacturing method according to some of the embodiments of the present disclosure, the first contact electrode CNE1 may be first formed, then a separate insulation layer may be formed on the first contact electrode CNE1, and the second contact electrode CNE2 may be formed on the insulation layer. In this case, the manufacturing process of the display device may be complicated.

Therefore, the manufacturing method of the display device according to some embodiments of the present disclosure may more simply and easily form the first contact electrode CNE1 and the second contact electrode CNE2, without further process (and mask), without limitation of the exposer, and by using the step (or thickness deviation) and etching technology of the photoresist PR by the second insulation layer INS2_1.

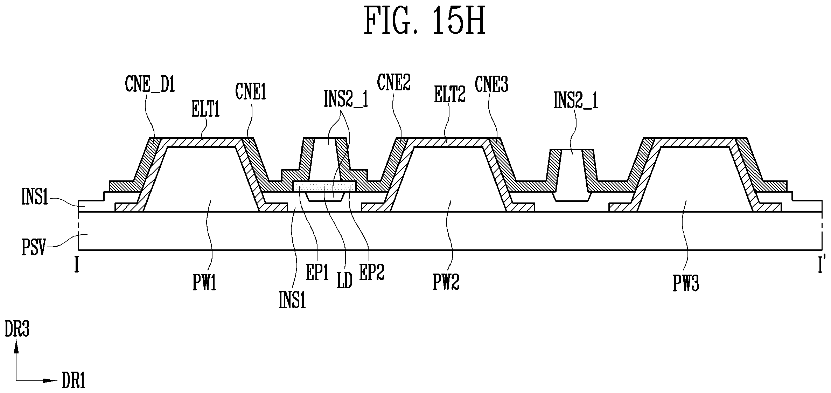

Referring to FIG. 15H, a residue of the photoresist PR may be removed. For example, by using a separate stripper (e.g., stripper for removing dry etching residue, photoresist stripper, etc.), the photoresist PR that remains in a region not overlapping with the first and second bank patterns PW1 and PW2 may be removed.

Next, the third insulation layer INS3 may be entirely formed on one surface of the substrate SUB to cover the first and second bank patterns PW1 and PW2 (and third bank pattern PW3), the first and second electrodes ELT1 and ELT2, the light emitting elements LD, the first to third contact electrodes CNE1, CNE2, and CNE3, and the dummy contact electrode CNE_D1.

As described with reference to FIGS. 15A to 15H, the manufacturing method of the display device according to some embodiments of the present disclosure may form the second insulation layer INS2_1 to have the thickness within the range of about 50% to about 150% of the thickness of the first bank pattern PW1 (and/or second bank pattern PW2), may form the photoresist PR on the contact electrode layer CNE0, and may remove a portion of the photoresist PR and a portion of the contact electrode layer CNE0 (e.g., may remove a portion overlapping with the second insulation layer INS2_1) through dry etching technology, thereby forming the first contact electrode CNE1 and the second contact electrode CNE2. That is, the first contact electrode CNE1 and the second contact electrode CNE2 may be concurrently or substantially simultaneously formed without a separate mask. Therefore, the manufacturing process of the display device may be simplified.

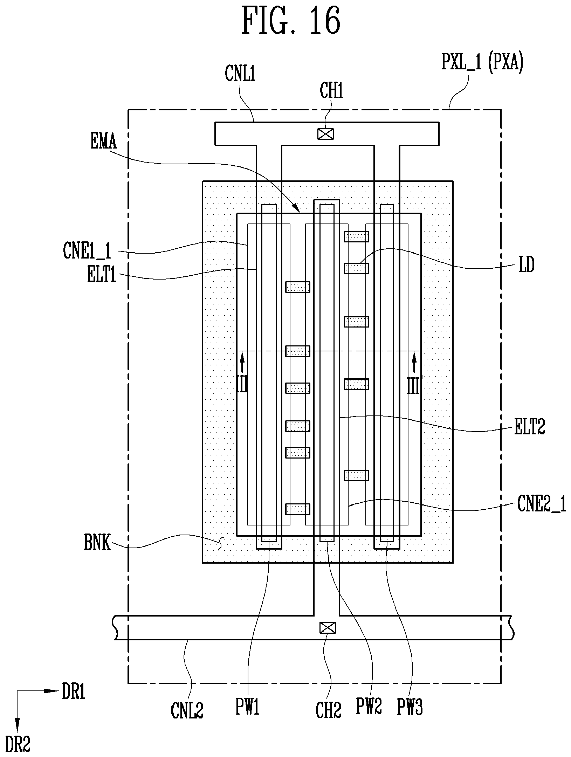

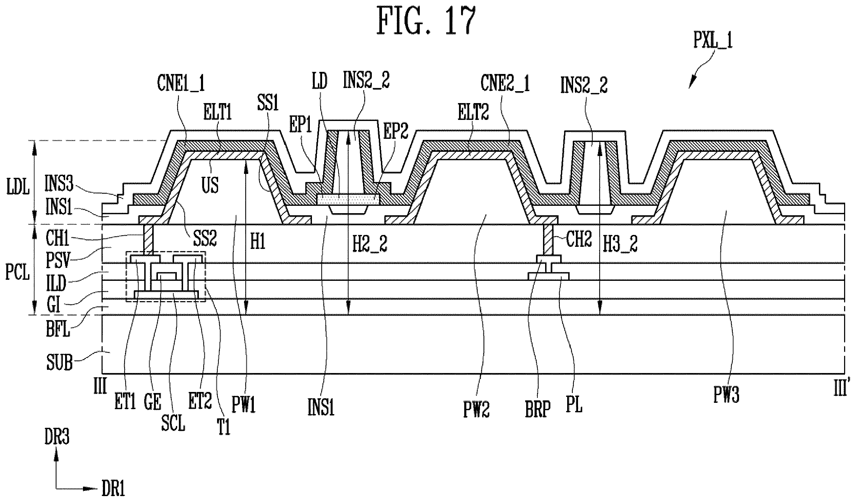

FIG. 16 is a top plan view showing an example of a pixel included in a display device of FIG. 5. FIG. 16 shows the drawing corresponding to FIG. 8. FIG. 17 is a cross-sectional view showing an example of a pixel taken along the line III-III' of FIG. 16. FIG. 17 shows the drawing corresponding to FIG. 9.

First, referring to FIGS. 8 and 16, the pixel PXL_1 is different from the pixel PXL of FIG. 8, in that the pixel PXL_1 includes a first contact electrode CNE1_1 and a second contact electrode CNE2_1. Because the pixel PXL_1 is otherwise substantially equal to or similar to the pixel PXL of FIG. 8, except for the first contact electrode CNE1_1 and second contact electrode CNE2_1, duplicate descriptions will be omitted.

The first contact electrode CNE1_1 may be formed on the first end EP1 of the light emitting elements LD, and on at least one region of the first electrode ELT1 corresponding thereto, to physically and/or electrically connect the first end EP1 of the light emitting elements LD to the first electrode EL T1. The width of the first contact electrode CNE1_1 in the first direction DR1 may be greater than the width of the first bank pattern PW1 in the first direction DR1.

Similarly, the second contact electrode CNE2_1 may be formed on the second end EP2 of the light emitting elements LD, and on at least one region of the second electrode ELT2 corresponding thereto, to physically and/or electrically connect the second end EP2 of the light emitting elements LD to the second electrode ELT2. The width of the second contact electrode CNE2_1 in the first direction DR1 may be greater than the width of the second bank pattern PW2 in the first direction DR1.

Referring to FIGS. 9 and 17, the pixel PXL_1 is different from the pixel PXL of FIG. 9 in that the pixel PXL_1 includes the second insulation layer INS2_2 (or insulation pattern), the first contact electrode CNE1_1, and the second contact electrode CNE2_1.

Because the pixel PXL_1 is substantially equal to or similar to the pixel PXL of FIG. 9 except for the second insulation layer INS2_2, the first contact electrode CNE1_1, and the second contact electrode CNE2_1, duplicate descriptions will be omitted.

The thickness of the second insulation layer INS2_2 may be within a range of about 100% to about 150% of the thickness of the first bank pattern PW1 and/or the second bank pattern PW2. For example, when the thickness TH1 of the first bank pattern PW1 is about 2 µm, the thickness of the second insulation layer INS2_2 may be within a range of about 2 µm to about 3 µm, or may be about 2 µm.

With respect to the substrate SUB, the height H2_2 of the upper surface of the second insulation layer INS2_2 may be greater than the height H1 of the first bank pattern PW1 and/or the second bank pattern PW2.

For example, the height H2_2 of the second insulation layer INS2 overlapping with the light emitting element LD may be greater than the height of the upper surface of the first electrode EL T1. For example, the height H3_2 of the second insulation layer INS2_2 that does not overlap with the light emitting element LD may be greater than or substantially equal to the height of the upper surface of the first electrode ELT1.

In this case, the first contact electrode CNE1_1 may be continuously formed on the upper surface US and the first and second side surfaces SS1 and SS2 of the first bank pattern PW1 (or of the first electrode ELT1). That is, the first contact electrode CNE1_1 may cover the first bank pattern PW1 (or the first electrode ELT1) without separation on the upper surface US of the first bank pattern PW1.

Similarly, the second contact electrode CNE2_1 may be continuously formed on the upper surface and both side surfaces of the second bank pattern PW2 (or on the second electrode ELT2). That is, the second contact electrode CNE2_1 may cover the second bank pattern PW2 (or the second electrode ELT2) without separation on the upper surface of the second bank pattern PW2.

As described with reference to FIGS. 16 and 17, the thickness of the second insulation layer INS2_2 may be within a range of about 100% to about 150% of the thickness of the first bank pattern PW1 and/or the second bank pattern PW2, and the height of the upper surface of the second insulation layer INS2_2 may be greater than or equal to the height of the upper surface of the first and second bank patterns PW1 and PW2 (or of the upper surface of the first and second electrodes ELT1 and ELT2) with respect to the substrate SUB. Therefore, respective contact areas between the first and second contact electrodes CNE1_1 and CNE2_1 and the first and second electrodes ELT1 and ELT2 may be increased, so that the first and second electrodes ELT1 and ELT2 and the light emitting element LD may be more stably connected.

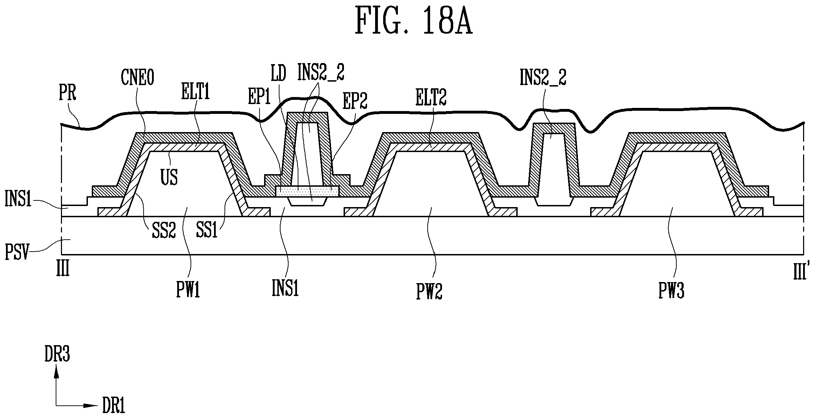

FIGS. 18A to 18C are cross-sectional views sequentially showing a manufacturing method of a display device according to some embodiments of the present disclosure. In FIGS. 18A to 18C, drawings corresponding to FIGS. 15F to 15H are shown. In FIGS. 18A to 18C, the structure thereof is schematically shown focusing some constituent elements of the pixel circuit layer PCL described with reference to FIG. 17, and a repeated detailed description thereof will be omitted.

First, referring to FIGS. 17 and 18A, a structure including the passivation layer PSV (or pixel circuit layer PCL formed on the substrate SUB), the first and second bank patterns PW1 and PW2 (and third bank pattern PW3), the first and second electrodes ELT1 and ELT2, the first insulation layer INS1, the light emitting element LD, the second insulation layer INS2_2, and the contact electrode layer CNE0, may be prepared.

As described with reference to FIGS. 15A to 15E, the first and second bank patterns PW1 and PW2 (and third bank pattern PW3), the first and second electrodes ELT1 and ELT2, the first insulation layer INS1, the light emitting element LD, the second insulation layer INS2_2, and the contact electrode layer CNE0 are sequentially formed on the passivation layer PSV.

As described with reference to FIG. 17, the thickness of the second insulation layer INS2_2 may be within a range of about 100% to about 150% of the thickness of the first bank pattern PW1 and/or the second bank pattern PW2. As described with reference to FIG. 17, with respect to the substrate SUB, the height of the upper surface US of the second insulation layer INS2_2 may be greater than the height H1 of the upper surface US of the first bank pattern PW1, and may also be greater than the height of the upper surface of the first electrode ELT1.

The photoresist PR (or photoresist layer) is formed on the contact electrode layer CNE0. The photoresist PR may be filled between the first bank pattern PW1 and second insulation layer INS2_2, and between the second bank pattern PW2 and second insulation layer INS2_2. Meanwhile, because the upper surface of the second insulation layer INS2_2 protrudes further than the upper surface of the first and second electrodes ELT1 and ELT2 (or the upper surface of the first and second bank patterns PW1 and PW2), the photoresist PR on the second insulation layer INS2_2 may spread toward the first and second electrodes ELT1 and ELT2, and the thickness of the photoresist PR overlapping with the second insulation layer INS2_2 may be less than the thickness of other portions of the photoresist PR (e.g., a portion not overlapping with the second insulation layer INS2_2).

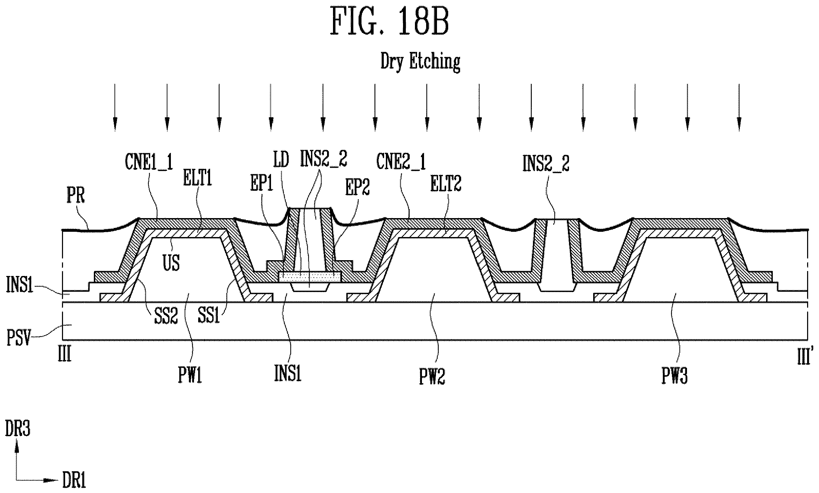

Referring to FIG. 18B, a portion of the photoresist PR overlapping with the second insulation layer INS2_2 and a portion of the contact electrode layer CNE0 is removed through an etching process (or etching technology). For example, through dry etching technology, the structure shown in FIG. 18A may be entirely etched by a given thickness (e.g., by a thickness in the third direction DR3 from the upper surface of the photoresist PR overlapping with the second insulation layer INS2_2 to the upper surface of the second insulation layer INS2_2). Accordingly, a portion of the contact electrode layer CNE0 overlapping with the second insulation layer INS2_2 is removed, thereby forming the first contact electrode CNE1_1 and the second contact electrode CNE2_1.

Only a portion of the photoresist PR overlapping with the second insulation layer INS2_2 may be removed, and the photoresist PR overlapping with, for example, the first and second bank patterns PW1 and PW2 may remain. Therefore, the first contact electrode CNE1_1 may be maintained as one electrode without separation as a plurality of contact electrodes on the first bank pattern PW1. Similarly, the second contact electrode CNE2_1 may be maintained as a single uniform electrode, and not a plurality of separated contact electrodes, on the second bank pattern PW2.

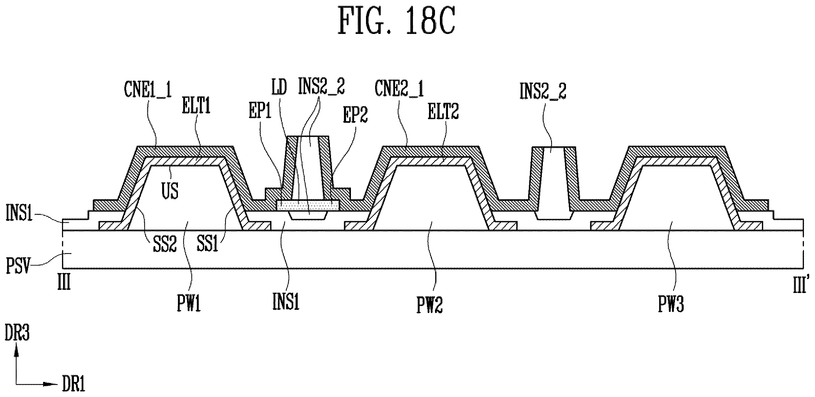

Referring to FIG. 18C, the residue of the photoresist PR may be removed. For example, the photoresist PR remaining in a region not overlapping with the second insulation layer INS2_2 may be removed by using a separate stripping solution.

Next, the third insulation layer INS3 may be entirely formed on one surface of the substrate SUB to cover the first and second bank patterns PW1 and PW2 (and third bank pattern PW3), the first and second electrodes ELT1 and ELT2, the light emitting elements LD, and the first and second contact electrodes CNE1_1 and CNE2_1.

As described with reference to FIGS. 18A to 18C, the manufacturing method of the display device according to some embodiments of the present disclosure may form the second insulation layer INS2_2 to have the thickness within the range of about 100% to about 150% of the thickness of the first bank pattern PW1 (and/or, second bank pattern PW2), and may form the photoresist PR on the contact electrode layer CNE0. In addition, the manufacturing method of the display device may form the first and second contact electrodes CNE1_1 and CNE2_1 covering the first and second bank patterns PW1 and PW2, respectively, in a plane view, by removing only a portion of the photoresist PR and a portion of the contact electrode layer CNE0 (e.g., a portion overlapping with the second insulation layer INS2_2) through dry etching technology.

The scope of the invention is determined by the accompanying claims. In addition, all changes or modifications that come within the scope of the claims will be interpreted as including the invention.

## Claims

1. A display device comprising:
a substrate (SUB);
a first bank pattern (PW1) and a second bank pattern (PW2) on the substrate (SUB) and spaced apart from each other;
a first electrode (ELT1) on the first bank pattern (PW1), and a second electrode (ELT2) on the second bank pattern (PW2);
a light emitting element (LD) between the first bank pattern (PW1) and the second bank pattern (PW2);
an insulation pattern (INS2) on the light emitting element (LD), and exposing a first end (EP1) and a second end (EP2) of the light emitting element (LD) respectively adjacent to the first bank pattern (PW1) and the second bank pattern (PW2);
a third electrode (CNE1) contacting the first electrode (ELT1) and the first end (EP1) of the light emitting element (LD); and
a fourth electrode (CNE2) contacting the second electrode (ELT2) and the second end (EP2) of the light emitting element (LD),
**characterized in that**
a thickness (TH2) of the insulation pattern (INS2) is within a range of about 50% to about 150% of a thickness (TH1) of the first bank pattern (PW1).

2. A display device according to claim 1, wherein the third electrode (CNE1) and the fourth electrode (CNE2) comprise the same material, and are formed on the same layer.

3. A display device according to claim 1 or claim 2, wherein, with respect to the substrate (SUB), a maximum height (H2) of an upper surface (US) of the insulation pattern (INS2) is greater than or equal to a height of an upper surface (US) of the first bank pattern (PW1) or second bank pattern (PW2).

4. A display device according to claim 3, wherein, with respect to the substrate (SUB), the maximum height (H2) of the upper surface (US) of the insulation pattern (INS2) is equal to the height (H1) of the upper surface (US) of the first bank pattern (PW1).

5. A display device according to claim 3 or claim 4, wherein the insulation pattern (INS2) comprises side surfaces (SS1, SS2) respectively facing the first electrode (ELT1) and the second electrode (ELT2), and an upper surface (US) between the side surfaces (SS1, SS2), and
wherein the third electrode (CNE1) does not overlap with the upper surface (US) of the insulation pattern (INS2).

6. A display device according to claim 5, wherein the first bank pattern (PW1) comprises a first side surface (SS1) facing the first end (EP1) of the light emitting element (LD), and an upper surface (US) that is parallel to the upper surface of the substrate (SUB), and
wherein the third electrode (CNE1) is on the first side surface (SS1) of the first bank pattern (PW1), optionally wherein the third electrode (CNE1) does not overlap with the upper surface of the first bank pattern (PW1).

7. A display device according to claim 6, further comprising
a dummy electrode (CNE_D1) spaced apart from the third electrode (CNE1), and contacting a second side surface (SS2) of the first bank pattern (PW1) facing the first side surface (SS1) of the first bank pattern (PW1); and
a fifth electrode (CNE3) on one side surface of the second bank pattern (PW2), and spaced apart from the fourth electrode (CNE2).

8. A display device according to claim 6 or claim 7, wherein, with respect to the substrate (SUB), a height of one end of the third electrode (CNE1) contacting the first end (EP1) of the light emitting element (LD) is equal to a height of the other end of the third electrode (CNE1) contacting the first electrode (ELT1).

9. A display device according to any one of claims 1 to 8, wherein a distance between the third electrode (CNE1) and the fourth electrode (CNE2) varies along a direction (DR2) in which the third and fourth electrodes (CNE1, CNE2) extend in a plane view, optionally wherein:
a distance (D1) between the third electrode (CNE1) and the fourth electrode (CNE2) in an overlapping portion that overlaps the light emitting element (LD) is greater than a distance (D2) between the third electrode (CNE1) and the fourth electrode (CNE2) in a non-overlapping portion that does not overlap the light emitting element (LD).

10. A display device according to any one of claims 1 to 9, wherein, with respect to the substrate (SUB), a height (H2) of an upper surface (US) of the insulation pattern (INS2) overlapping with the light emitting element (LD) is equal to a maximum height of an upper surface of the first electrode (ELT1), and a height (H3) of the upper surface (US) of the insulation pattern (INS2) that does not overlap with the light emitting element (LD) is about equal to a height (H1) of the upper surface (US) of the first bank pattern (PW1).

11. A display device according to any one of claims 1 to 10, wherein, with respect to the substrate (SUB), a height (H2_2) of an upper surface (US) of the insulation pattern (INS2_2) is greater than a maximum height of an upper surface of the first electrode (ELT1), optionally wherein:
the first bank pattern (PW1) comprises an upper surface (US) that is parallel to the upper surface of the substrate (SUB), and
wherein the third electrode (CNE1_1) overlaps with the upper surface (US) of the first bank pattern (PW).

12. A display device according to any one of claims 1 to 11, further comprising a pixel circuit layer (PCL) between the substrate (SUB) and the first bank pattern (PW1), and comprising at least one transistor (T1) electrically connected to the first electrode (ELT1) or the second electrode (ELT2), optionally wherein:
the first bank pattern (PW1_1) directly covers one of a source electrode (ET1) or a drain electrode (ET2) of the at least one transistor (T1), which is connected to the first electrode (ELT1) or to the second electrode (ELT2) through a contact hole (CH1_1) in the first bank pattern (PW1_1).

13. A manufacturing method of a display device comprising:
forming a first bank pattern (PW1) and a second bank pattern (PW2) spaced apart on a substrate (SUB);
forming a first electrode (ELT1) and a second electrode (ELT2) on the first bank pattern (PW1) and the second bank pattern (PW2), respectively;
aligning a light emitting element (LD) between the first bank pattern (PW1) and the second bank pattern (PW2);
forming an insulation pattern (INS2_1) exposing a first end (EP1) and a second end (EP2) of the light emitting element (LD) that are adjacent to the first bank pattern (PW1) and the second bank pattern (PW2) on the light emitting element (LD), respectively;
forming an electrode layer (CNE0) covering the first electrode (ELT1), the second electrode (ELT2), and the insulation pattern (INS2_1) on the substrate (SUB);
**characterized by**
forming a photoresist (PR) on the electrode layer (CNEO); and
forming a third electrode (CNE1) and a fourth electrode (CNE2) from the electrode layer (CNE0) by using an etching technology to remove at least a portion of the photoresist (PR) and a first portion of the electrode layer (CNE0) that overlaps with the insulation pattern (INS2_1).

14. A manufacturing method according to claim 13, wherein a thickness (TH2) of the insulation pattern (INS2_1) is within a range of 50% to about 150% of a thickness (TH1) of the first bank pattern (PW1).

15. A manufacturing method according to claim 14, wherein:
(i) the forming the third electrode (CNE1) and the fourth electrode (CNE2) comprises forming a dummy electrode (CNE_D1) from the electrode layer (CNE0) by removing a portion of the electrode layer (CNE0) overlapping with the first bank pattern (PW1), the dummy electrode (CNE_D1) being spaced apart from the third electrode (CNE1); and/or
(ii) with respect to the substrate (SUB), a height of an upper surface (US) of the insulation pattern (INS2_1) is greater than a maximum height of an upper surface of the first electrode (ELT1).

## Patentansprüche

1. Anzeigegerät, das Folgendes umfasst:
ein Substrat (SUB);
eine erste Dammstruktur (PW1) und eine zweite Dammstruktur (PW2) auf dem Substrat (SUB), die voneinander beabstandet sind;
eine erste Elektrode (ELT1) auf der ersten Dammstruktur (PW1) und eine zweite Elektrode (ELT2) auf der zweiten Dammstruktur (PW2);
ein lichtemittierendes Element (LD) zwischen der ersten Dammstruktur (PW1) und der zweiten Dammstruktur (PW2);
eine Isolationsstruktur (INS2) auf dem lichtemittierenden Element (LD), die ein erstes Ende (EP1) und ein zweites Ende (EP2) des lichtemittierenden Elements (LD) jeweils neben der ersten Dammstruktur (PW1) und der zweiten Dammstruktur (PW2) exponiert;
eine dritte Elektrode (CNE1), die mit der ersten Elektrode (ELT1) und dem ersten Ende (EP1) des lichtemittierenden Elements (LD) in Kontakt steht; und
eine vierte Elektrode (CNE2), die mit der zweiten Elektrode (ELT2) und dem zweiten Ende (EP2) des lichtemittierenden Elements (LD) in Kontakt steht;
**dadurch gekennzeichnet, dass**
eine Dicke (TH2) der Isolationsstruktur (INS2) innerhalb eines Bereichs von etwa 50 % bis etwa 150 % einer Dicke (TH1) der ersten Dammstruktur (PW1) liegt.

2. Anzeigegerät nach Anspruch 1, wobei die dritte Elektrode (CNE1) und die vierte Elektrode (CNE2) aus demselben Material bestehen und auf derselben Schicht ausgebildet sind.

3. Anzeigegerät nach Anspruch 1 oder Anspruch 2, wobei in Bezug auf das Substrat (SUB) eine maximale Höhe (H2) einer oberen Fläche (US) der Isolationsstruktur (INS2) größer als oder genauso groß wie eine Höhe einer oberen Fläche (US) der ersten Dammstruktur (PW1) oder zweiten Dammstruktur (PW2) ist.

4. Anzeigegerät nach Anspruch 3, wobei in Bezug auf das Substrat (SUB) die maximale Höhe (H2) der oberen Fläche (US) der Isolationsstruktur (INS2) gleich der Höhe (H1) der oberen Fläche (US) der ersten Dammstruktur (PW1) ist.

5. Anzeigegerät nach Anspruch 3 oder Anspruch 4, wobei die Isolationsstruktur (INS2) Seitenflächen (SS1, SS2), die der ersten Elektrode (ELT1) bzw. der zweiten Elektrode (ELT2) zugewandt sind, und eine obere Fläche (US) zwischen den Seitenflächen (SS1, SS2) umfasst, und
wobei die dritte Elektrode (CNE1) nicht mit der oberen Fläche (US) der Isolationsstruktur (INS2) überlappt.

6. Anzeigegerät nach Anspruch 5, wobei die erste Dammstruktur (PW1) eine dem ersten Ende (EP1) des lichtemittierenden Elements (LD) zugewandte erste Seitenfläche (SS1) und eine obere Fläche (US) parallel zur oberen Fläche des Substrats (SUB) umfasst, und
wobei sich die dritte Elektrode (CNE1) auf der ersten Seitenfläche (SS1) der ersten Dammstruktur (PW1) befindet, wobei die dritte Elektrode (CNE1) optional nicht mit der oberen Fläche der ersten Dammstruktur (PW1) überlappt.

7. Anzeigegerät nach Anspruch 6, das ferner Folgendes umfasst:
eine Blindelektrode (CNE_D1), die von der dritten Elektrode (CNE1) beabstandet ist und mit einer zweiten Seitenfläche (SS2) der ersten Dammstruktur (PW1) in Kontakt steht, die der ersten Seitenfläche (SS1) der ersten Dammstruktur (PW1) zugewandt ist; und
eine fünfte Elektrode (CNE3) auf einer Seitenfläche der zweiten Dammstruktur (PW2), die von der vierten Elektrode (CNE2) beabstandet ist.

8. Anzeigegerät nach Anspruch 6 oder Anspruch 7, wobei in Bezug auf das Substrat (SUB) eine Höhe eines Endes der dritten Elektrode (CNE1), das mit dem ersten Ende (EP1) des lichtemittierenden Elements (LD) in Kontakt steht, gleich einer Höhe des anderen Endes der dritten Elektrode (CNE1) ist, das mit der ersten Elektrode (ELT1) in Kontakt steht.

9. Anzeigegerät nach einem der Ansprüche 1 bis 8, wobei ein Abstand zwischen der dritten Elektrode (CNE1) und der vierten Elektrode (CNE2) entlang einer Richtung (DR2) variiert, in der sich die dritte und die vierte Elektrode (CNE1, CNE2) in einer Draufsicht erstrecken, wobei optional:
ein Abstand (D1) zwischen der dritten Elektrode (CNE1) und der vierten Elektrode (CNE2) in einem überlappenden Abschnitt, der das lichtemittierende Element (LD) überlappt, größer ist als ein Abstand (D2) zwischen der dritten Elektrode (CNE1) und der vierten Elektrode (CNE2) in einem nicht überlappenden Abschnitt, der das lichtemittierende Element (LD) nicht überlappt.

10. Anzeigegerät nach einem der Ansprüche 1 bis 9, wobei in Bezug auf das Substrat (SUB) eine Höhe (H2) einer oberen Fläche (US) der Isolationsstruktur (INS2), die mit dem lichtemittierenden Element (LD) überlappt, gleich einer maximalen Höhe einer oberen Fläche der ersten Elektrode (ELT1) ist, und eine Höhe (H3) der oberen Fläche (US) des Isolationsmusters (INS2), die nicht mit dem lichtemittierenden Element (LD) überlappt, etwa gleich einer Höhe (H1) der oberen Fläche (US) der ersten Dammstruktur (PW1) ist.

11. Anzeigegerät nach einem der Ansprüche 1 bis 10, wobei in Bezug auf das Substrat (SUB) eine Höhe (H2_2) einer oberen Fläche (US) der Isolationsstruktur (INS2_2) größer ist als eine maximale Höhe einer oberen Fläche der ersten Elektrode (ELT1), wobei optional:
die erste Dammstruktur (PW1) eine obere Fläche (US) umfasst, die parallel zur oberen Fläche des Substrats (SUB) ist, und
wobei die dritte Elektrode (CNE1_1) mit der oberen Fläche (US) der ersten Dammstruktur (PW) überlappt.

12. Anzeigegerät nach einem der Ansprüche 1 bis 11, das ferner eine Pixelschaltungsschicht (PCL) zwischen dem Substrat (SUB) und der ersten Dammstruktur (PW1) umfasst und mindestens einen Transistor (T1) umfasst, der elektrisch mit der ersten Elektrode (ELT1) oder der zweiten Elektrode (ELT2) verbunden ist, wobei optional:
die erste Dammstruktur (PW1_1) direkt eine einer Source-Elektrode (ET1) oder einer Drain-Elektrode (ET2) des mindestens einen Transistors (T1) bedeckt, die mit der ersten Elektrode (ELT1) oder der zweiten Elektrode (ELT2) durch ein Kontaktloch (CH1_1) in der ersten Dammstruktur (PW1_1) verbunden ist.

13. Verfahren zur Herstellung eines Anzeigegeräts, das Folgendes umfasst:
Ausbilden einer ersten Dammstruktur (PW1) und einer zweiten Dammstruktur (PW2), die auf einem Substrat (SUB) voneinander beabstandet sind;
Ausbilden einer ersten Elektrode (ELT1) und einer zweiten Elektrode (ELT2) auf der ersten Dammstruktur (PW1) bzw. der zweiten Dammstruktur (PW2);
Ausrichten eines lichtemittierenden Elements (LD) zwischen der ersten Dammstruktur (PW1) und der zweiten Dammstruktur (PW2);
Ausbilden einer Isolationsstruktur (INS2_1), die ein erstes Ende (EP1) und ein zweites Ende (EP2) des lichtemittierenden Elements (LD) exponiert, die neben der ersten Dammstruktur (PW1) bzw. der zweiten Dammstruktur (PW2) auf dem lichtemittierenden Element (LD) liegen;
Ausbilden einer Elektrodenschicht (CNE0), die die erste Elektrode (ELT1), die zweite Elektrode (ELT2) und die Isolationsstruktur (INS2_1) auf dem Substrat (SUB) bedeckt;
**gekennzeichnet durch**
Ausbilden eines Photoresists (PR) auf der Elektrodenschicht (CNEO); und
Ausbilden einer dritten Elektrode (CNE1) und einer vierten Elektrode (CNE2) aus der Elektrodenschicht (CNE0) durch Verwenden einer Ätztechnologie, um mindestens einen Abschnitt des Photoresists (PR) und einen ersten Abschnitt der Elektrodenschicht (CNE0), der mit der Isolationsstruktur (INS2_1) überlappt, zu entfernen.

14. Herstellungsverfahren nach Anspruch 13, wobei eine Dicke (TH2) des Isolationsmusters (INS2_1) in einem Bereich von 50% bis etwa 150% einer Dicke (TH1) der ersten Dammstruktur (PW1) liegt.

15. Herstellungsverfahren nach Anspruch 14, wobei:
(i) das Ausbilden der dritten Elektrode (CNE1) und der vierten Elektrode (CNE2) das Ausbilden einer Blindelektrode (CNE_D1) aus der Elektrodenschicht (CNE0) durch Entfernen eines mit der ersten Dammstruktur (PW1) überlappenden Abschnitts der Elektrodenschicht (CNE0) umfasst, wobei die Blindelektrode (CNE_D1) von der dritten Elektrode (CNE1) beabstandet ist; und/oder
(ii) in Bezug auf das Substrat (SUB) eine Höhe einer oberen Fläche (US) der Isolationsstruktur (INS2_1) größer als eine maximale Höhe einer oberen Fläche der ersten Elektrode (ELT1) ist.

## Revendications

1. Dispositif d'affichage, comprenant :
un substrat (SUB) ;
un premier motif de banc (PW1) et un second motif de banc (PW2) sur le substrat (SUB) et espacés l'un de l'autre ;
une première électrode (ELT1) sur le premier motif de banc (PW1), et une deuxième électrode (ELT2) sur le second motif de banc (PW2) ;
un élément électroluminescent (LD) entre le premier motif de banc (PW1) et le second motif de banc (PW2) ;
un motif d'isolation (INS2) sur l'élément électroluminescent (LD), et exposant une première extrémité (EP1) et une seconde extrémité (EP2) de l'élément électroluminescent (LD) respectivement adjacentes au premier motif de banc (PW1) et au second motif de banc (PW2) ;
une troisième électrode (CNE1) venant en contact avec la première électrode (ELT1) et la première extrémité (EP1) de l'élément électroluminescent (LD) ; et
une quatrième électrode (CNE2) venant en contact avec la deuxième électrode (ELT2) et la seconde extrémité (EP2) de l'élément électroluminescent (LD),
**caractérisé en ce que** :
une épaisseur (TH2) du motif d'isolation (INS2) est comprise entre environ 50 % et environ 150 % d'une épaisseur (TH1) du premier motif de banc (PW1).

2. Dispositif d'affichage selon la revendication 1, dans lequel la troisième électrode (CNE1) et la quatrième électrode (CNE2) sont constituées du même matériau, et sont formées sur la même couche.

3. Dispositif d'affichage selon la revendication 1 ou la revendication 2, dans lequel, par rapport au substrat (SUB), une hauteur maximale (H2) d'une surface supérieure (US) du motif d'isolation (INS2) est supérieure ou égale à une hauteur d'une surface supérieure (US) du premier motif de banc (PW1) ou du second motif de banc (PW2).

4. Dispositif d'affichage selon la revendication 3, dans lequel, par rapport au substrat (SUB), la hauteur maximale (H2) de la surface supérieure (US) du motif d'isolation (INS2) est égale à la hauteur (H1) de la surface supérieure (US) du premier motif de banc (PW1).

5. Dispositif d'affichage selon la revendication 3 ou la revendication 4, dans lequel le motif d'isolation (INS2) comprend des surfaces latérales (SS1, SS2) faisant face respectivement à la première électrode (ELT1) et à la deuxième électrode (ELT2), et une surface supérieure (US) entre les surfaces latérales (SS1, SS2), et
dans lequel la troisième électrode (CNE1) ne chevauche pas la surface supérieure (US) du motif d'isolation (INS2).

6. Dispositif d'affichage selon la revendication 5, dans lequel le premier motif de banc (PW1) comprend une première surface latérale (SS1) faisant face à la première extrémité (EP1) de l'élément électroluminescent (LD), et une surface supérieure (US) qui est parallèle à la surface supérieure du substrat (SUB), et
dans lequel la troisième électrode (CNE1) est sur la première surface latérale (SS1) du premier motif de banc (PW1), facultativement dans lequel la troisième électrode (CNE1) ne chevauche pas la surface supérieure du premier motif de banc (PW1).

7. Dispositif d'affichage selon la revendication 6, comprenant en outre :
une électrode factice (CNE_D1) espacée de la troisième électrode (CNE1), et venant en contact avec une seconde surface latérale (SS2) du premier motif de banc (PW1) faisant face à la première surface latérale (SS1) du premier motif de banc (PW1) ; et
une cinquième électrode (CNE3) sur une surface latérale du second motif de banc (PW2), et espacée de la quatrième électrode (CNE2).

8. Dispositif d'affichage selon la revendication 6 ou la revendication 7, dans lequel, par rapport au substrat (SUB), une hauteur d'une extrémité de la troisième électrode (CNE1) venant en contact avec la première extrémité (EP1) de l'élément électroluminescent (LD) est égale à une hauteur de l'autre extrémité de la troisième électrode (CNE1) venant en contact avec la première électrode (ELT1).

9. Dispositif d'affichage selon l'une quelconque des revendications 1 à 8, dans lequel une distance entre la troisième électrode (CNE1) et la quatrième électrode (CNE2) varie le long d'une direction (DR2) dans laquelle les troisième et quatrième électrodes (CNE1, CNE2) s'étendent dans une vue de dessus, facultativement dans lequel :
une distance (D1) entre la troisième électrode (CNE1) et la quatrième électrode (CNE2) dans une partie de chevauchement qui chevauche l'élément électroluminescent (LD) est supérieure à une distance (D2) entre la troisième électrode (CNE1) et la quatrième électrode (CNE2) dans une partie non chevauchante qui ne chevauche pas l'élément électroluminescent (LD).

10. Dispositif d'affichage selon l'une quelconque des revendications 1 à 9, dans lequel, par rapport au substrat (SUB), une hauteur (H2) d'une surface supérieure (US) du motif d'isolation (INS2) chevauchant l'élément électroluminescent (LD) est égale à une hauteur maximale d'une surface supérieure de la première électrode (ELT1), et une hauteur (H3) de la surface supérieure (US) du motif d'isolation (INS2) qui ne chevauche pas l'élément électroluminescent (LD) est à peu près égale à une hauteur (H1) de la surface supérieure (US) du premier motif de banc (PW1).

11. Dispositif d'affichage selon l'une quelconque des revendications 1 à 10, dans lequel, par rapport au substrat (SUB), une hauteur (H2_2) d'une surface supérieure (US) du motif d'isolation (INS2_2) est supérieure à une hauteur maximale d'une surface supérieure de la première électrode (ELT1), facultativement dans lequel :
le premier motif de banc (PW1) comprend une surface supérieure (US) qui est parallèle à la surface supérieure du substrat (SUB), et
dans lequel la troisième électrode (CNE1_1) chevauche la surface supérieure (US) du premier motif de banc (PW).

12. Dispositif d'affichage selon l'une quelconque des revendications 1 à 11, comprenant en outre une couche de circuit de pixel (PCL) entre le substrat (SUB) et le premier motif de banc (PW1), et comprenant au moins un transistor (T1) connecté électriquement à la première électrode (ELT1) ou à la deuxième électrode (ELT2), facultativement dans lequel :
le premier motif de banc (PW1_1) recouvre directement l'une parmi une électrode de source (ET1) ou une électrode de drain (ET2) du au moins un transistor (T1), qui est connectée à la première électrode (ELT1) ou à la deuxième électrode (ELT2) par l'intermédiaire d'un trou de contact (CH1_1) dans le premier motif de banc (PW1_1).

13. Procédé de fabrication d'un dispositif d'affichage comprenant les étapes consistant à :
former un premier motif de banc (PW1) et un second motif de banc (PW2) espacés l'un de l'autre sur un substrat (SUB) ;
former une première électrode (ELT1) et une deuxième électrode (ELT2) sur le premier motif de banc (PW1) et le second motif de banc (PW2), respectivement ;
aligner un élément électroluminescent (LD) entre le premier motif de banc (PW1) et le second motif de banc (PW2) ;
former un motif d'isolation (INS2_1) exposant une première extrémité (EP1) et une seconde extrémité (EP2) de l'élément électroluminescent (LD) qui sont adjacentes au premier motif de banc (PW1) et au second motif de banc (PW2), respectivement, sur l'élément électroluminescent (LD) ;
former une couche d'électrode (CNE0) recouvrant la première électrode (ELT1), la deuxième électrode (ELT2) et le motif d'isolation (INS2_1) sur le substrat (SUB) ;
**caractérisé par** :
la formation d'une résine photosensible (PR) sur la couche d'électrode (CNE0) ; et
la formation d'une troisième électrode (CNE1) et d'une quatrième électrode (CNE2) à partir de la couche d'électrode (CNE0) en utilisant une technologie de gravure pour éliminer au moins une partie de la résine photosensible (PR) et une première partie de la couche d'électrode (CNE0) qui chevauche le motif d'isolation (INS2_1).

14. Procédé de fabrication selon la revendication 13, dans lequel une épaisseur (TH2) du motif d'isolation (INS2_1) est comprise dans une plage de 50 % à environ 150 % d'une épaisseur (TH1) du premier motif de banc (PW1).

15. Procédé de fabrication selon la revendication 14, dans lequel :
(i) la formation de la troisième électrode (CNE1) et de la quatrième électrode (CNE2) comprend la formation d'une électrode factice (CNE_D1) à partir de la couche d'électrode (CNE0) en éliminant une partie de la couche d'électrode (CNE0) chevauchant le premier motif de banc (PW1), l'électrode factice (CNE_D1) étant espacée de la troisième électrode (CNE1) ; et/ou
(ii) par rapport au substrat (SUB), une hauteur d'une surface supérieure (US) du motif d'isolation (INS2_1) est supérieure à une hauteur maximale d'une surface supérieure de la première électrode (ELT1).
